# EUROPEAN PATENT APPLICATION

(11) **EP 4 788 106 A1**
(43) Date of publication of application: **05.08.2026**
(21) Application number: 26152859.0
(22) Date of filing: 20.01.2026
(51) Int. Cl.: H10K 59/40, H10K 59/80, G06F 3/041

(54) **DISPLAY DEVICE, ELECTRONIC DEVICE INCLUDING THE SAME, AND METHOD FOR MANUFACTURING DISPLAY DEVICE**

(30) Priority: 03.02.2025 KR 20250013295
(71) Applicant: Samsung Display Co., Ltd., Yongin-si, Gyeonggi-do 17113 (KR)
(72) Inventor: Kim, Kyeongjong, Yongin-si, Gyeonggi-do 17113 (KR); Kim, Sujeong, Yongin-si, Gyeonggi-do 17113 (KR); Kim, Wooyoung, Yongin-si, Gyeonggi-do 17113 (KR); Lazo Martinez, Israel Esteban, Yongin-si, Gyeonggi-do 17113 (KR); Lee, Jungwoo, Yongin-si, Gyeonggi-do 17113 (KR); Lee, Jinhyeong, Yongin-si, Gyeonggi-do 17113 (KR)
(74) Representative: Gulde & Partner

(57) **Abstract**

A display device (1) includes a substrate (100), a display layer (200) arranged on the substrate (100) and including a light-emitting diode (OLED) and a bank layer (225), defines a lower opening (225OP) therein defining an emission area (EA) of the light-emitting diode (OLED), a touch sensor layer (500) arranged on the display layer (200) and including an upper touch electrode (MT2) and an upper touch insulating layer (520) covering the upper touch electrode (MT2), and an optical control layer (600) arranged on the touch sensor layer (500) and including a light-shielding layer (610) and a light-shielding pattern (610D). The light-shielding layer (610) defines an upper opening (610OP) therein overlapping the lower opening (225OP) in a plan view, and the light-shielding pattern (610D) is arranged within the upper opening (610OP). The touch sensor layer (500) further includes a reflective pattern (RP), which overlaps the emission area (EA) in the plan view, the light-shielding pattern (610D) overlaps the reflective pattern (RP), and an upper surface of the reflective pattern (RP) directly contacts a lower surface of the light-shielding pattern (610D).

## Description

### BACKGROUND

### 1. Field

One or more embodiments relate to a display device, an electronic device including the same, and a method of manufacturing a display device.

### 2. Description of the Related Art

Display devices visually display data. Display devices may be used as displays of small-sized products such as mobile phones or large products such as televisions.

A display device includes a plurality of pixels emitting light by receiving electrical signals to externally display images. Each pixel includes a display element, and for example, an organic light-emitting display device includes organic light-emitting diodes (OLEDs) as display elements.

Recently, as the use of display devices has diversified, various designs have been made to improve the quality of display devices.

### SUMMARY

One or more embodiments provide a display device with improved display quality, an electronic device including the display device, and a method of manufacturing a display device. However, this is merely an example, and the scope of the present disclosure is not limited thereto.

Additional aspects will be set forth in part in the description which follows and, in part, will be apparent from the description, or may be learned by practice of the presented embodiments of the disclosure.

According to one or more embodiments, a display device includes a substrate, a display layer arranged on the substrate and including a light-emitting diode and a bank layer, which defines a lower opening therein defining an emission area of the light-emitting diode, a touch sensor layer arranged on the display layer and including an upper touch electrode and an upper touch insulating layer covering the upper touch electrode, and an optical control layer arranged on the touch sensor layer and including a light-shielding layer and a light-shielding pattern, where the light-shielding layer defines an upper opening therein overlapping the lower opening in a plan view, and the light-shielding pattern is arranged within the upper opening. The touch sensor layer further includes a reflective pattern, which is arranged at the same layer as the upper touch electrode and overlaps the emission area in the plan view, the light-shielding pattern is arranged on the reflective pattern to cover the reflective pattern in the plan view, and an upper surface of the reflective pattern directly contacts a lower surface of the light-shielding pattern.

In an embodiment, the upper touch insulating layer may define an intermediate opening therein overlapping the reflective pattern, and the light-shielding pattern may be arranged within the intermediate opening.

In an embodiment, the upper surface of the reflective pattern may be exposed by the intermediate opening.

In an embodiment, a surface contact angle of the reflective pattern may be greater than a surface contact angle of the upper touch insulating layer.

In an embodiment, a length from an upper surface of the upper touch insulating layer to an upper surface of the light-shielding layer may be greater than a length from the upper surface of the upper touch insulating layer to an upper surface of the light-shielding pattern.

In an embodiment, the touch sensor layer may further include a lower touch electrode arranged under the upper touch electrode and a lower touch insulating layer arranged between the upper touch electrode and the lower touch electrode, and the upper touch electrode may be electrically connected to the lower touch electrode.

In an embodiment, the lower touch insulating layer may define a trench located at the center of the emission area, and the reflective pattern may be arranged within the trench.

In an embodiment, the reflective pattern may have a V shape or a wing-like shape in a cross-sectional view.

In an embodiment, the reflective pattern may be arranged on an upper surface of the lower touch insulating layer, and the reflective pattern may have a flat shape or a wave shape in the cross-sectional view.

In an embodiment, the light-shielding pattern may be spaced apart from the light-shielding layer and may include the same material as the light-shielding layer.

In an embodiment, the optical control layer may further include a color filter layer, which is arranged on the light-shielding layer and fills the upper opening, and the color filter layer may cover the light-shielding pattern.

In an embodiment, the reflective pattern may include a first sub-reflective pattern and a second sub-reflective pattern, which are arranged apart from each other, the light-shielding pattern may include a first sub-light-shielding pattern arranged on the first sub-reflective pattern and a second sub-light-shielding pattern arranged on the second sub-reflective pattern, and the first sub-light-shielding pattern may be spaced apart from the second sub-light-shielding pattern.

According to one or more embodiments, a method of manufacturing a display device includes forming, on a substrate, a display layer including a light-emitting diode, patterning a first touch electrode on the display layer, depositing a first touch insulating layer to cover the first touch electrode, patterning, on the first touch insulating layer, a second touch electrode electrically connected to the first touch electrode and a reflective pattern overlapping an emission area of the light-emitting diode, depositing a second touch insulating layer to cover the second touch electrode and the reflective pattern, forming, in the second touch insulating layer, a touch insulating layer opening overlapping the reflective pattern in a plan view, and forming a light-shielding layer arranged on the second touch insulating layer and a light-shielding pattern arranged within the touch insulating layer opening.

In an embodiment, the forming of the touch insulating layer opening may include removing some portions of the second touch insulating layer, which overlap the reflective pattern, through a dry etching process.

In an embodiment, the touch insulating layer opening in the second touch insulating layer may expose an upper surface of the reflective pattern, and the upper surface of the reflective pattern may directly contact a lower surface of the light-shielding pattern.

In an embodiment, the light-shielding layer may define a light-shielding layer opening therein, which overlaps the emission area, and in the plan view, the light-shielding pattern may be arranged within the light-shielding layer opening and spaced apart from the light-shielding layer.

In an embodiment, the method may further include forming a color filter layer arranged on the light-shielding layer and filling the light-shielding layer opening, wherein the color filter layer may cover the light-shielding pattern.

In an embodiment, the light-shielding layer and the light-shielding pattern may be formed through the same process and include the same material.

In an embodiment, the method may further include performing surface treatment on an upper surface of the reflective pattern, which is exposed through the touch insulating layer opening after the forming of the touch insulating layer opening and before the forming of the light-shielding pattern, where the upper surface of the reflective pattern is surface-treated through plasma treatment or Self-assembled monolayer (SAM) treatment.

According to one or more embodiments, an electronic device includes a display device configured to provide an image, a housing configured to accommodate the display device, where the display device includes a substrate, a display layer arranged on the substrate and including a light-emitting diode and a bank layer, which defines a lower opening therein defining an emission area of the light-emitting diode, a touch sensor layer arranged on the display layer and including a touch electrode and a touch insulating layer covering the touch electrode, and an optical control layer arranged on the touch sensor layer and including a light-shielding layer and a light-shielding pattern, where the light-shielding layer defines an upper opening therein overlapping the lower opening in a plan view, and the light-shielding pattern is arranged within the upper opening, the touch sensor layer further includes a reflective pattern, which is arranged on the same layer as the touch electrode and overlaps the emission area in the plan view, the light-shielding pattern is arranged to overlap the reflective pattern in the plan view, an upper surface of the reflective pattern directly contacts a lower surface of the light-shielding pattern, and the display device further includes at least one of a display module, a processor, a memory, or a power module.

The invention is defined by the appended set of claims. The description that follows is subjected to this limitation. Any disclosure lying outside the scope of said claims is only intended for illustrative as well as comparative purposes.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic perspective view of a display device according to an embodiment;
FIG. 2 is an equivalent circuit diagram illustrating a light-emitting diode included in any one of sub-pixels of a display device and a sub-pixel circuit connected to the light-emitting diode, according to an embodiment;
FIG. 3 is a schematic cross-sectional view of a display device according to an embodiment, taken along line I-I' of FIG. 1;
FIG. 4 is a schematic plan view of a display device according to an embodiment;
FIG. 5 is a schematic cross-sectional view of a display device according to an embodiment;
FIG. 6 is a schematic cross-sectional view of a display device according to an embodiment, illustrating enlarged region VII of FIG. 5;
FIGS. 7A to 7D are schematic cross-sectional views illustrating a method of manufacturing a display device, according to an embodiment;
FIGS. 8A to 9D are schematic cross-sectional views of display devices according to embodiments;
FIG. 10 is a block diagram of an electronic device according to an embodiment; and
FIG. 11 is a schematic diagram of electronic devices according to embodiments.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b, or c" indicates only a, only b, only c, both a and b, both a and c, both b and c, all of a, b, and c, or variations thereof.

As the disclosure allows for various changes and numerous embodiments, particular embodiments will be shown in the drawings and described in detail in the written description. The attached drawings for illustrating embodiments of the disclosure are referred to in order to gain a sufficient understanding of the present disclosure, the merits thereof, and the objectives accomplished by the implementation of the disclosure. The disclosure may, however, be embodied in many different forms and should not be construed as being limited to the embodiments set forth herein.

One or more embodiments of the present disclosure will be described more fully with reference to the accompanying drawings, like reference numerals in the drawings denote like elements, and repeated descriptions thereof will not be provided.

It will be understood that although the terms "first," "second," etc. may be used herein to describe various components, these components should not be limited by these terms. These components are only used to distinguish one component from another.

As used herein, the singular forms "a," "an," and "the" are intended to include the plural forms as well, unless the context clearly indicates otherwise.

It will be further understood that the terms "comprises" and/or "comprising" used herein specify the presence of stated features or components, but do not preclude the presence or addition of one or more other features or components.

It will be understood that when a layer, region, or element is referred to as being "formed on" another layer, region, or element, it can be directly or indirectly formed on the other layer, region, or element. That is, for example, intervening layers, regions, or elements may be present.

Sizes of elements in the drawings may be exaggerated for convenience of explanation. In other words, since sizes and thicknesses of elements in the drawings are arbitrarily illustrated for convenience of explanation, the following embodiments are not limited thereto.

When a certain embodiment may be implemented differently, a specific process order may be performed differently from the described order. For example, two consecutively described processes may be performed substantially at the same time or performed in an order opposite to the described order.

It will be understood that when a layer, region, or component is referred to as being connected to another layer, region, or component, it can be directly or indirectly connected to the other layer, region, or component. For example, when a layer, region, or component is referred to as being electrically connected to another layer, region, or component, it can be directly or indirectly electrically connected to the other layer, region, or component.

In the following examples, the x-axis, the y-axis, and the z-axis are not limited to three axes of the rectangular coordinate system, and may be interpreted in a broader sense. For example, the x-axis, the y-axis, and the z-axis may be perpendicular to one another, or may represent different directions that are not perpendicular to one another.

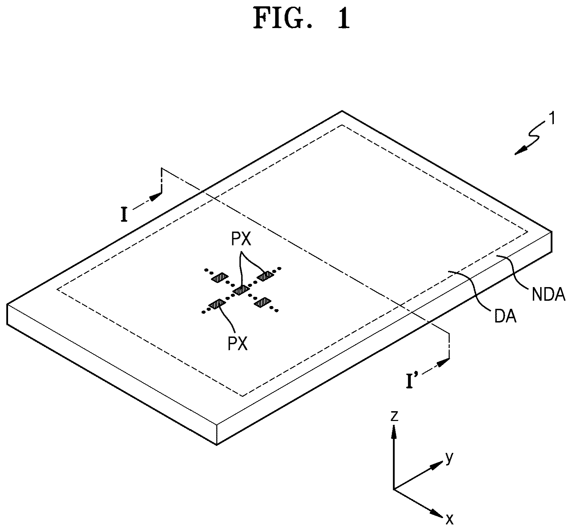

FIG. 1 is a schematic perspective view of a display device according to an embodiment.

Referring to FIG. 1, a display device 1 may include a display area DA and a peripheral area NDA outside the display area DA. The display device 1 may provide an image through an array of sub-pixels PX that are two-dimensionally arranged in the display area DA.

Each sub-pixel PX of the display device 1 may be a region where light having a certain color may be emitted, and the display device 1 may provide an image by using light emitted from the sub-pixels PX. For example, each sub-pixel PX may emit red light, green light, blue light, or white light.

Each sub-pixel PX may emit light of a certain color by using a light-emitting diode, for example, an organic light-emitting diode. Each organic light-emitting diode may emit, for example, red light, green light, blue light, or white light. Each organic light-emitting diode may be connected to a sub-pixel circuit that includes a thin-film transistor and a capacitor.

The peripheral area NDA may be an area where no images are displayed and may entirely surround the display area DA. In the peripheral area NDA, drivers or main voltage lines configured to provide electrical signals or power to sub-pixel circuits may be arranged. In the peripheral area NDA, a pad that may be electrically connected to an electronic component or a printed circuit board may be included.

The display area DA may have a polygonal shape including a rectangular shape, as illustrated in FIG. 1. For example, the display area DA may have a rectangular shape in which a horizontal length is greater than a vertical length or the horizontal length is less than the vertical length, or may have a square shape. Alternatively, the display area DA may have various shapes, such as an oval shape or a circular shape.

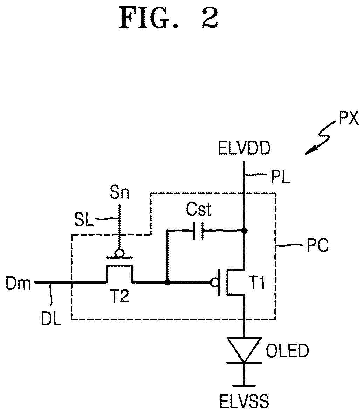

FIG. 2 illustrates a light-emitting diode included in any one of sub-pixels of a display device and a sub-pixel circuit connected to the light-emitting diode, according to an embodiment.

Referring to FIG. 2, an organic light-emitting diode OLED is connected to a sub-pixel circuit PC as a light-emitting diode. The sub-pixel circuit PC may include a first thin-film transistor T1, a second thin-film transistor T2, and a storage capacitor Cst.

The second thin-film transistor T2 is a switching thin-film transistor and may be electrically connected to a scan line SL and a data line DL and configured to transmit a data signal Dm, which is input through the data line DL, to the first thin-film transistor T1, according to a scan voltage or a scan signal Sn that is input through the scan line SL.

The storage capacitor Cst may be electrically connected to the second thin-film transistor T2 and a driving voltage line PL and may be configured to store a voltage corresponding to the difference between a voltage from the second thin-film transistor T2 and a driving voltage ELVDD provided to the driving voltage line PL.

The first thin-film transistor T1 is a driving thin-film transistor and may be electrically connected to the driving voltage line PL and the storage capacitor Cst and configured to control a driving current flowing in the organic light-emitting diode OLED from the driving voltage line PL, according to the voltage stored in the storage capacitor Cst. The organic light-emitting diode OLED may emit light having a certain brightness according to the driving current. A sub-pixel electrode (e.g., an anode) of the organic light-emitting diode OLED may be connected to the sub-pixel circuit PC. An opposite electrode (e.g., a cathode) of the organic light-emitting diode OLED may receive a common voltage ELVSS.

FIG. 2 illustrates that the sub-pixel circuit PC includes two thin-film transistors and one storage capacitor. However, in another embodiment, the number of thin-film transistors or the number of storage capacitors may vary according to the design of the sub-pixel circuit PC.

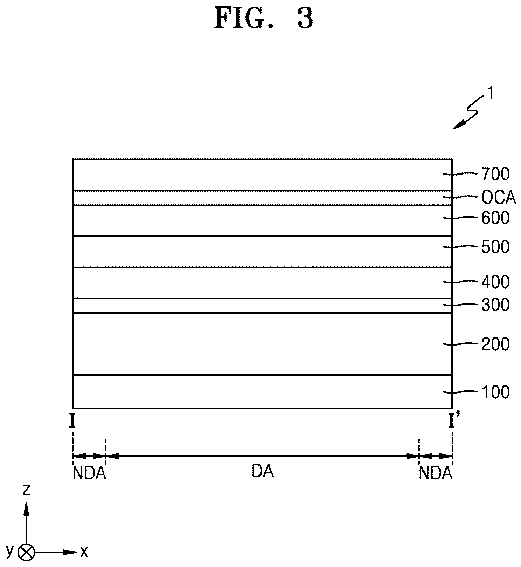

FIG. 3 is a schematic cross-sectional view of the display device 1 according to an embodiment, taken along line I-I' of FIG. 1.

Referring to FIG. 3, the display device 1 may include a substrate 100, a display layer 200, a low reflection layer 300, an encapsulation layer 400, a touch sensor layer 500, an optical control layer 600, an adhesive layer OCA, and a cover window 700.

The substrate 100 may include glass or polymer resin. For example, polymer resin may include polyether sulfone, polyacrylate, polyetherimide, polyethylene naphthalate, polyethylene terephthalate, polyphenylene sulfide, polyarylate, polyimide, polycarbonate, cellulose acetate propionate, or the like. The substrate 100 including polymer resin may be flexible, rollable, or bendable. The substrate 100 may have a multilayered structure that includes a layer, which includes polymer resin, and an inorganic layer (not shown).

The display layer 200 may include a light-emitting diode, for example, an organic light-emitting diode, a thin-film transistor electrically connected to the organic light-emitting diode, and insulating layers arranged therebetween.

The low reflection layer 300 may be arranged on the display layer 200, and the encapsulation layer 400 may be arranged on the low reflection layer 300. For example, the display layer 200 and/or the low reflection layer 300 may be sealed by the encapsulation layer 400. In some embodiments, the low reflection layer 300 may be omitted. In this case, the encapsulation layer 400 may be directly arranged on the display layer 200. The encapsulation layer 400 may include at least one inorganic encapsulation layer and at least one organic encapsulation layer.

In the present specification, the description that "B is arranged on A" may indicate that B is arranged on a structure including A. In this case, the "up and down" direction may be determined based on the thickness direction of the substrate 100 or a traveling direction of light emitted from the light emitting diode. Specifically, the expression "B is arranged on A" may indicate that B is arranged closer to the cover window 700 than A, and A is closer to the substrate 100 than B.

In some embodiments, an encapsulation substrate (not shown) including a glass material may be provided instead of the encapsulation layer 400. The encapsulation substrate may be arranged on the display layer 200, and the display layer 200 may be between the substrate 100 and the encapsulation substrate. A gap may exist between the encapsulation substrate and the display layer 200 and may be filled with fillers.

The touch sensor layer 500 may be arranged on the encapsulation layer 400. The touch sensor layer 500 may sense an external input, e.g., a touch from an object, such as a finger or a stylus pen, and allow the display device 1 to obtain coordinate information corresponding to a touch location. The touch sensor layer 500 may include a touch electrode and trace lines connected to the touch electrode. The touch sensor layer 500 may detect an external input in a mutual cap manner or a self-cap manner.

The touch sensor layer 500 may be directly formed on the encapsulation layer 400. Alternatively, after separately formed, the touch sensor layer 500 may adhere to the encapsulation layer 400 by an adhesive layer, such as an optically clear adhesive.

The optical control layer 600 may be arranged on the touch sensor layer 500. The optical control layer 600 may reduce the reflectivity of external light that is incident to the display device 1 from the outside through the cover window 700.

The optical control layer 600 may include a light-shielding layer and color filters. The color filters may be arranged by considering colors of light emitted from the light-emitting diodes of the display layer 200, respectively. In addition, the optical control layer 600 may further include a light-shielding pattern arranged at the center of the emission area. The light-shielding pattern may be spaced apart from the light-shielding layer, but may include the same material as the light-shielding layer or the color filters.

The cover window 700 may be arranged on the optical control layer 600. The cover window 700 may cover and protect layers. After separately formed, the cover window 700 may be attached to the optical control layer 600 by the adhesive layer OCA arranged between the cover window 700 and the optical control layer 600. The adhesive layer OCA may be, for example, an optically clear adhesive. Alternatively, the cover window 700 may be directly formed on the optical control layer 600.

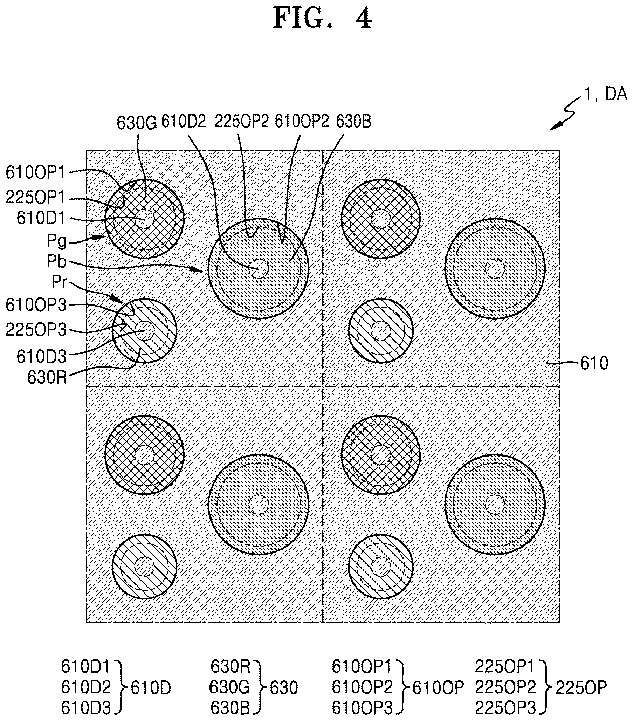

FIG. 4 is a schematic plan view of the display device 1 according to an embodiment. FIG. 4 illustrates a plan view of a light-shielding layer 610 for convenience. As used herein, the "plan view" is a view in a thickness direction (i.e., z-axis direction) of the display device 1.

Referring to FIG. 4, the display device 1 may include a plurality of sub-pixels. The plurality of sub-pixels may include a red sub-pixel Pr, a blue sub-pixel Pb, and a green sub-pixel Pg. The plurality of sub-pixels may include light-emitting diodes emitting light having colors corresponding to the sub-pixels. For example, the red sub-pixel Pr may emit light in a wavelength band of 580 nm to 780 nm, the blue sub-pixel Pb may emit light in a wavelength band of 380 nm to 495 nm, and the green sub-pixel Pg may emit light in a wavelength band of 495 nm to 580 nm.

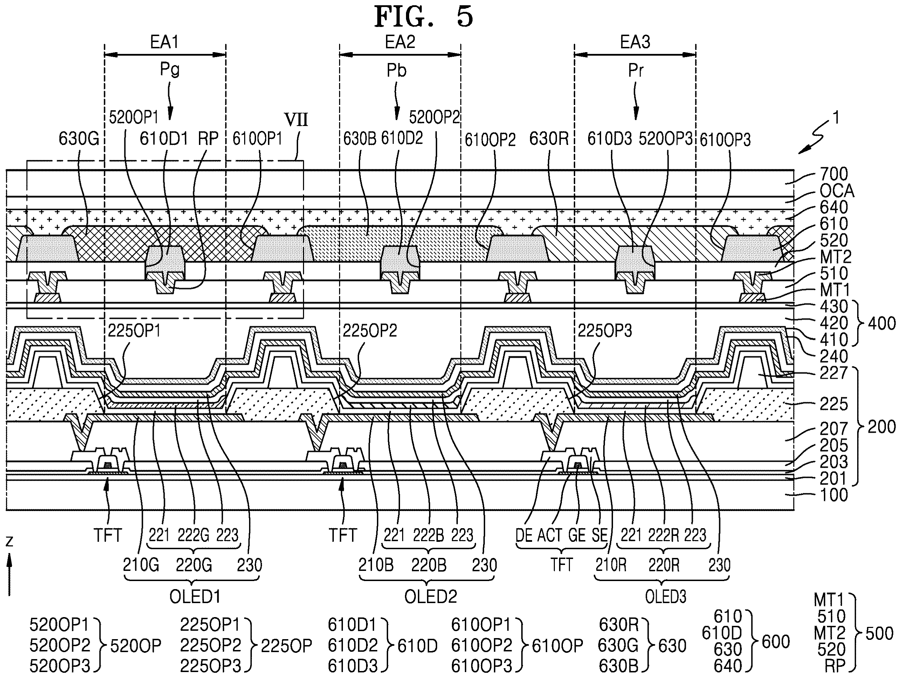

A bank layer (225, see FIG. 5) may define a lower opening 225OP therein, which defines the emission area of each sub-pixel. The light-emitting diode may include a sub-pixel electrode, an opposite electrode, and an emission layer arranged therebetween, the bank layer (225, see FIG. 5) may cover edges of the sub-pixel electrode, and the lower opening 225OP of the bank layer (225, see FIG. 5) may expose the central portion of the sub-pixel electrode. The emission layer of the light-emitting diode may be arranged within the lower opening 225OP of the bank layer (225, see FIG. 5). Specifically, the bank layer (225, see FIG. 5) may define a first lower opening 225OP1 therein defining the emission area of the green sub-pixel Pg, a second lower opening 225OP2 therein defining the emission area of the blue sub-pixel Pb, and a third lower opening 225OP3 therein defining the emission area of the red sub-pixel Pr.

As shown in FIG. 4, the first lower opening 225OP1 to the third lower opening 225OP3 may each have a circular shape when viewed in the direction perpendicular to the substrate (100, FIG. 5). In other words, the emission area of each of the green sub-pixel Pg, the blue sub-pixel Pb, and the red sub-pixel Pr may have a circular shape when viewed in the direction perpendicular to the substrate (100, FIG. 5). However, one or more embodiments are not limited thereto. For example, the first lower opening 225OP1 to the third lower opening 225OP3 may each have a polygonal shape or an oval shape.

The light-shielding layer 610 of the optical control layer (600, FIG. 3) described above may be arranged on the bank layer (225, FIG. 5) and the light-emitting diode. The light-shielding layer 610 may define upper openings 610OP therein corresponding to the emission areas, respectively. Specifically, the light-shielding layer 610 may define a first upper opening 610OP1 therein corresponding to the green sub-pixel Pg and overlapping the first lower opening 225OP1, a second upper opening 610OP2 therein corresponding to the blue sub-pixel Pb and overlapping the second lower opening 225OP2, and a third upper opening 610OP3 therein corresponding to the red sub-pixel Pr and overlapping the third lower opening 225OP3 in a plan view. The upper openings 610OP may be referred to as "light-shielding layer openings".

In the present specification, the expression "A overlaps B" may refer to a structure in which A and B are vertically aligned and appear to overlap each other in a plan view. For example, when the first lower opening 225OP1 is referred to as overlapping the first upper opening 610OP1, the first upper opening 610OP1 is arranged on the first lower opening 225OP1 to correspond to the same, and when viewed in the direction perpendicular to the substrate 100 (i.e., in a plan view), the first lower opening 225OP1 may appear to at least partially overlap the first upper opening 610OP1.

The upper opening 610OP of the light-shielding layer 610 may be filled with a color filter layer 630 of the optical control layer (600, FIG. 3). Specifically, the first upper opening 610OP1 may be filled with a first color filter 630G, the second upper opening 610OP2 may be filled with a second color filter 630B, and the third upper opening 610OP3 may be filled with a third color filter 630R.

Similar to the lower opening 225OP, the upper opening 610OP may also have a circular shape when viewed in the direction perpendicular to the substrate (100, FIG. 5). However, one or more embodiments are not limited thereto, and the shape of the upper opening 610OP may be modified according to the shape of the lower opening 225OP. However, the area of the upper opening 610OP may be greater than an area of the lower opening 225OP. This configuration is designed to maximize the efficiency of light emitted from the emission area. For example, the area of the first upper opening 610OP1 may be greater than the area of the first lower opening 225OP1 in a plan view. That is, in a plan view, the bank layer (225, FIG. 5) may be arranged to protrude further towards the emission area (or the center of each sub-pixel) than the light-shielding layer 610.

The optical control layer (600, FIG. 3) may further include light-shielding patterns 610D arranged within the upper openings 610OP of the light-shielding layer 610. The light-shielding patterns 610D may include a first light-shielding pattern 610D1 arranged within the first upper opening 610OP1, a second light-shielding pattern 610D2 arranged within the second upper opening 610OP2, and a third light-shielding pattern 610D3 arranged within the third upper opening 610OP3. The first light-shielding pattern 610D1 may overlap the emission area of the green sub-pixel Pg, the second light-shielding pattern 610D2 may overlap the emission area of the blue sub-pixel Pb, and the third light-shielding pattern 610D3 may overlap the emission area of the red sub-pixel Pr.

As described below, the light-shielding pattern 610D may include the same material as the light-shielding layer 610. Accordingly, the light-shielding pattern 610D may absorb part of external light that is incident to the display device 1, thereby reducing the external light reflectivity of the display device 1 and also improving the display quality of the display device 1.

As shown in FIG. 4, the light-shielding pattern 610D may have a circular shape in a plan view. However, one or more embodiments are not limited thereto, and the shape of the light-shielding pattern 610D may be modified according to the shapes of the upper opening 610OP and the lower opening 225OP. The light-shielding pattern 610D may be arranged at the central portion of its corresponding upper opening 610OP. For example, in a plan view, the light-shielding pattern 610D may be arranged such that the center of the light-shielding pattern 610D may be aligned with the center of the upper opening 610OP.

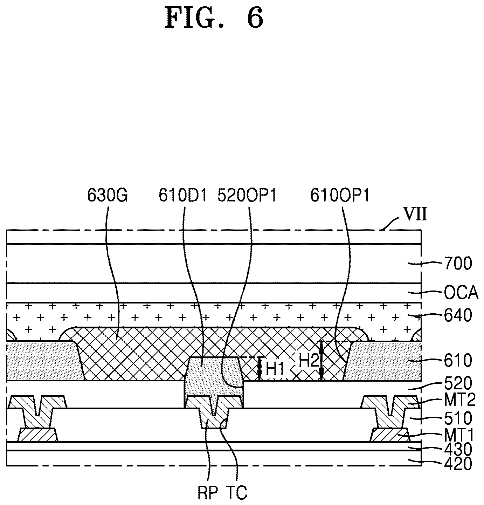

FIG. 5 is a schematic cross-sectional view of the display device 1, according to an embodiment. FIG. 6 is a schematic cross-sectional view of a display device according to an embodiment, illustrating enlarged region VII of FIG. 5.

Referring to FIG. 5, the display device 1 may include the substrate 100, the display layer 200, the encapsulation layer 400, the touch sensor layer 500, the optical control layer 600, the adhesive layer OCA, and the cover window 700.

The display device 1 may include a plurality of sub-pixels arranged in the display area (DA, FIG. 4). Each sub-pixel may include, for example, red light, green light, or blue light. The sub-pixels may include sub-pixels emitting light of different colors, for example, the green sub-pixel Pg, the blue sub-pixel Pb, and the red sub-pixel Pr. The green sub-pixel Pg, the blue sub-pixel Pb, and the red sub-pixel Pr may each be provided in plurality.

The display layer 200 may be arranged on the substrate 100. The display layer 200 may include a sub-pixel circuit layer and a light-emitting diode layer. The sub-pixel circuit layer may include a thin-film transistor TFT and also include insulating layers, that is, a buffer layer 201, a gate insulating layer 203, an interlayer insulating layer 205, and a planarization layer 207.

The buffer layer 201 may be disposed above the substrate 100, reduce or prevent the penetration of foreign materials, moisture, or external air from the bottom of the substrate 100, and provide a flat surface to the substrate 100. The buffer layer 201 may include an inorganic material, such as oxide or nitride, an organic material, or a compound of organic and inorganic materials and may have a single-layer structure or a multilayered structure including organic and inorganic materials. A barrier layer (not shown) may be further provided between the substrate 100 and the buffer layer 201, the barrier layer preventing the penetration of external air. For example, the buffer layer 201 may include silicon oxide (SiO₂) or silicon nitride (SiNₓ).

The thin-film transistor TFT may be arranged on the buffer layer 201. The thin-film transistor TFT may include a semiconductor layer ACT, a gate electrode GE, a source electrode SE, and a drain electrode DE. The thin-film transistor TFT may be connected to the organic light-emitting diode and thus drive the same.

A semiconductor layer ACT may be arranged on the buffer layer 201. The semiconductor layer ACT may include polysilicon or amorphous silicon. Alternatively, the semiconductor layer ACT may include oxide of at least one material selected from the group consisting of indium (In), gallium (Ga), tin (Sn), zirconium (Zr), vanadium (V), hafnium (Hf), cadmium (Cd), germanium (Ge), chromium (Cr), titanium (Ti), and zinc (Zn). The semiconductor layer ACT may include a channel area and source and drain areas doped with impurities.

The gate electrode GE, the source electrode SE, and the drain electrode DE may include various conductive materials. In an embodiment, the gate electrode GE may include at least one of molybdenum (Mo), aluminum (Al), copper (Cu), or titanium (Ti). For example, the gate electrode GE may be a single Mo layer or a three-layer structure including an Mo layer, an Al layer, and an Mo layer. In an embodiment, the source electrode SE and the drain electrode DE may each include at least one material selected from the group consisting of Cu, Ti, and Al. For example, the source electrode SE and the drain electrode DE may each have a three-layer structure including a Ti layer, an Al layer, and a Ti layer.

To insulate the semiconductor layer ACT from the gate electrode GE, the gate insulating layer 203 may be arranged between the semiconductor layer ACT and the gate electrode GE. The interlayer insulating layer 205 may be arranged on the gate electrode GE, and the source electrode SE and the drain electrode DE may be arranged on the interlayer insulating layer 205.

The gate insulating layer 203 and the interlayer insulating layer 205 may each include an inorganic material, such as SiO₂, SiNₓ, and/or SiON. The gate insulating layer 203 and the interlayer insulating layer 205 may be formed through, for example, Chemical Vapor Deposition (CVD) or Atomic Layer Deposition (ALD).

The planarization layer 207 may be arranged on the thin-film transistor TFT. To provide a flat upper surface, the planarization layer 207 is formed, and then, chemical mechanical polishing may be performed on the upper surface of the planarization layer 207. The planarization layer 207 may include a general-purpose polymer, such as photosensitive polyimide, polyimide, polystyrene (PS), polycarbonate (PC), benzocyclobutene (BCB), hexamethyldisiloxane (HMDSO), polymethylmethacrylate (PMMA), or polystyrene (PS), a polymer derivative having a phenol-based group, an acryl-based polymer, an imide-based polymer, an aryl-ether-based polymer, an amide-based polymer, a fluorine-based polymer, a p-xylene-based polymer, a vinyl alcohol-based polymer, or any blend thereof. FIG. 5 illustrates that the planarization layer 207 is a single layer, but in some embodiments, the planarization layer 207 may be layers. The first sub-pixel electrode 210G of the first organic light-emitting diode OLED1, the second sub-pixel electrode 210B of the second organic light-emitting diode OLED2, and the third sub-pixel electrode of the third organic light-emitting diode OLED3 may be electrically connected to the thin-film transistors TFT through contact holes in the planarization layer 207, respectively.

The light-emitting diode layer may be arranged on the sub-pixel circuit layer. In an embodiment, the light-emitting diode layer may include the first organic light-emitting diode OLED1 to the third organic light-emitting diode OLED3, a bank layer 225, and a spacer 227.

The first organic light-emitting diode OLED1 to the third organic light-emitting diode OLED3 may be arranged on the sub-pixel circuit layer. The first organic light-emitting diode OLED1 may have a stack structure including the first sub-pixel electrode 210G, a first intermediate layer 220G, which includes a first common layer 221, a first emission layer 222G, and a second common layer 223, and an opposite electrode 230; the second organic light-emitting diode OLED2 may include the second sub-pixel electrode 210B, a second intermediate layer 220B, which includes the first common layer 221, a second emission layer 222B, and the second common layer 223, and the opposite electrode 230; and the third organic light-emitting diode OLED3 may include the third sub-pixel electrode 210R, a third intermediate layer 220R, which includes the first common layer 221, a third emission layer 222R, and the second common layer 223, and the opposite electrode 230.

The first sub-pixel electrode 210G, the second sub-pixel electrode 210B, and the third sub-pixel electrode 210R may be arranged on the planarization layer 207. The first sub-pixel electrode 210G, the second sub-pixel electrode 210B, and the third sub-pixel electrode 210R may be arranged apart from each other. The first sub-pixel electrode 210G, the second sub-pixel electrode 210B, and the third sub-pixel electrode 210R may each be a reflection electrode. For example, the first sub-pixel electrode 210G, the second sub-pixel electrode 210B, and the third sub-pixel electrode 210R may each include a reflective layer and a transparent or translucent conductive layer, wherein the reflective layer includes silver (Ag), magnesium (Mg), Al, platinum (Pt), palladium (Pd), gold (Au), nickel (Ni), neodymium (Nd), iridium (Ir), chromium (Cr), or a compound thereof. The transparent or translucent conductive layer may include at least one material selected from the group consisting of indium tin oxide (ITO), indium zinc oxide (IZO), zinc oxide (ZnO), indium oxide (In₂O₃), indium gallium oxide (IGO), and aluminum zinc oxide (AZO).

The bank layer 225 may be arranged on the first sub-pixel electrode 210G, the second sub-pixel electrode 210B, and the third sub-pixel electrode 210R. The bank layer 225 may define the lower openings 225OP therein that overlap the first sub-pixel electrode 210G, the second sub-pixel electrode 210B, and the third sub-pixel electrode 210R and expose central portions of the first sub-pixel electrode 210G, the second sub-pixel electrode 210B, and the third sub-pixel electrode 210R, respectively. The bank layer 225 may cover edges of the first sub-pixel electrode 210G, the second sub-pixel electrode 210B, and the third sub-pixel electrode 210R and may increase the distances between the edges and the opposite electrode 230, thereby preventing arcs from being generated at the edges of the first sub-pixel electrode 210G, the second sub-pixel electrode 210B, and the third sub-pixel electrode 210R.

The lower openings 225OP of the bank layer 225 may define a first emission area EA1 to a third emission area EA3 of the first organic light-emitting diode OLED1 to the third organic light-emitting diode OLED3 that are respectively included in the sub-pixels. As shown in FIG. 5, the bank layer 225 may include the first lower opening 225OP1, which defines the first emission area EA1 of the first organic light-emitting diode OLED1 of the green sub-pixel Pg. In addition, the bank layer 225 may include the second lower opening 225OP2 defining the second emission area EA2 of the second organic light-emitting diode OLED2 of the blue sub-pixel Pb and the third lower opening 225OP3 defining the third emission area EA3 of the third organic light-emitting diode OLED3 of the red sub-pixel Pr.

The bank layer 225 may include an organic insulating material. Alternatively, the bank layer 225 may include an inorganic insulating material, such as SiNₓ or SiO₂. In some embodiments, the bank layer 225 may include an organic insulating material and an inorganic insulating material.

In an embodiment, the bank layer 225 may include a light-shielding material. For example, the light-shielding material of the bank layer 225 may be black. The light-shielding material may include carbon black, carbon nanotubes, resin or paste including a black dye, metal particles such as Ni, Al, Mo, and an alloy thereof, metal oxide particles, metal nitride particles, or the like. When the bank layer 225 includes the light-shielding material, external light reflection from metal structures arranged under the bank layer 225 may decrease.

The spacer 227 may be arranged on the bank layer 225. The spacer 227 may include an organic insulating material, such as polyimide. Alternatively, the spacer 227 may include an inorganic insulating material, such as SiNₓ or SiO₂, or both an organic insulating material and an inorganic insulating material. In an embodiment, the spacer 227 may include a material that is different from a material of the bank layer 225 including the aforementioned light-shielding material, and the spacer 227 and the bank layer 225 may be formed through separate processes. In another embodiment, the spacer 227 may include the same material as the bank layer 225. In this case, the bank layer 225 and the spacer 227 may be formed together in a mask process using a halftone mask and the like.

The intermediate layers may be arranged on the first sub-pixel electrode 210G, the second sub-pixel electrode 210B, the third sub-pixel electrode 210R, and the bank layer 225. As described above, the intermediate layer may include the first common layer 221, the emission layer, and the second common layer 223.

The first emission layer 222G, the second emission layer 222B, and the third emission layer 222R may be arranged within the first lower opening 225OP1, the second lower opening 225OP2, and the third lower opening 225OP3 of the bank layer 225, respectively. The first emission layer 222G, the second emission layer 222B, and the third emission layer 222R may each include an organic material containing a fluorescent material or a phosphorescent material capable of emitting green light, blue light, or red light. The organic material may be a low-molecular-weight organic material or a high-molecular-weight organic material.

The first common layer 221 and the second common layer 223 may be arranged on and under the emission layer, respectively. The first common layer 221 may include, for example, a Hole Transport Layer (HTL) or both an HTL and a Hole Injection Layer (HIL). The second common layer 223 may include, for example, an Electron Transport Layer (ETL) or both an ETL and an Electron Injection Layer (EIL). In an embodiment, the second common layer 223 may not be provided.

While the emission layers are respectively arranged on the sub-pixels to correspond to the first lower opening 225OP1 to the third lower opening 225OP3 of the bank layer 225, the first common layer 221 and the second common layer 223 may each be integrally formed with each other to entirely cover the substrate 100. In other words, the first common layer 221 and the second common layer 223 may each be integrally formed to entirely cover the display area (DA, FIG. 4) of the substrate 100.

The opposite electrode 230 may be a cathode that is an electron injection electrode. The opposite electrode 230 may include a conductive material having a low work function. For example, the opposite electrode 230 may include a (translucent) transparent layer including Ag, Mg, Al, Pt, Pd, Au, Ni, Nd, Ir, Cr, lithium (Li), calcium (Ca), or an alloy thereof. Alternatively, the opposite electrode 230 may further include a layer including ITO, IZO, ZnO, or In₂O₃ on the transparent (or translucent) layer including the above material.

In an embodiment, a capping layer 240 may be further arranged on the display layer 200. The capping layer 240 may be arranged on the first organic light-emitting diode OLED1 to the third organic light-emitting diode OLED3. In an embodiment, the capping layer 240 may improve the emission efficiency of the first organic light-emitting diode OLED1 to the third organic light-emitting diode OLED3 based on the principle of constructive interference.

The capping layer 240 may include an organic capping layer including an organic material, an inorganic capping layer including an inorganic material, or a compound capping layer including both an organic material and an inorganic material. For example, the capping layer 240 may include a carbocyclic compound, a heterocyclic compound, an amine group-containing compound, porphine derivatives, phthalocyanine derivatives, naphthalocyanine derivatives, alkali metal complexes, alkali earth metal complexes, or an arbitrary combination thereof. The carbocyclic compound, the heterocyclic compound, and the amine group-containing compound may be optionally substituted with a substituent including oxygen (O), nitrogen (N), sulfur (S), selenium (Se), silicon (Si), fluorine (F), chlorine (CI), bromine (Br), iodine (I), or an arbitrary combination thereof.

The encapsulation layer 400 may be arranged on the capping layer 240. The encapsulation layer 400 may include at least one inorganic encapsulation layer and at least one organic encapsulation layer. For example, as shown in FIG. 5, the encapsulation layer 400 may include a first inorganic encapsulation layer 410, an organic encapsulation layer 420, and a second inorganic encapsulation layer 430, which are sequentially stacked.

The first inorganic encapsulation layer 410 and the second inorganic encapsulation layer 430 may include an inorganic insulating material, such as SiO₂, SiNₓ, SiON, aluminum oxide (Al₂O₃), titanium oxide (TiO₂), tantalum oxide (Ta₂O₅), hafnium oxide (HfO₂), or ZnO. The first inorganic encapsulation layer 410 and the second inorganic encapsulation layer 430 may each be a layer or layers including the above inorganic insulating material.

The organic encapsulation layer 420 may relieve internal stress of the first inorganic encapsulation layer 410 and/or the second inorganic encapsulation layer 430. The organic encapsulation layer 420 may include a polymer-based material. For example, the organic encapsulation layer 420 may include polyethylene terephthalate, polyethylene naphthalate, polycarbonate, polyimide, polyethylene sulfonate, polyoxymethylene, polyarylate, HMDSO, acrylic resin (e.g., PMMA, polyacrylic acid, etc.), or an arbitrary combination thereof.

The encapsulation layer 400 may have a multilayered structure including the first inorganic encapsulation layer 410, the organic encapsulation layer 420, and the second inorganic encapsulation layer 430. In this case, even if cracks occur in the encapsulation layer 400, such cracks may not propagate between the first inorganic encapsulation layer 410 and the organic encapsulation layer 420 or between the organic encapsulation layer 420 and the second inorganic encapsulation layer 430. The encapsulation layer 400 may prevent or reduce the penetration of external moisture or oxygen into the display area DA.

The touch sensor layer 500 may be arranged on the encapsulation layer 400. The touch sensor layer 500 may include a first touch electrode (MT1, or a lower touch electrode), a first touch insulating layer (510, or a lower touch insulating layer), a second touch electrode (MT2, or an upper touch electrode), and a second touch insulating layer (520, or an upper touch insulating layer). The first touch electrode MT1 may be directly arranged on the encapsulation layer 400. For example, the first touch electrode MT1 may be directly arranged on the second inorganic encapsulation layer 430 of the encapsulation layer 400. However, one or more embodiments are not limited thereto. Connecting the upper touch MT2 electrode to a lower touch electrode MT1 through the lower touch insulating layer 510 reduces the overall resistance of the touch sensor structure. This dual-electrode configuration allows both layers to function as sensors, which accelerates the detection of touch inputs and improves sensitivity. Furthermore, this configuration supports a mesh structure that permits light to pass through, minimizing interference with the display's emission.

In an embodiment, the touch sensor layer 500 may include an insulating layer (not shown) between the first touch electrode MT1 and the encapsulation layer 400. In this case, the insulating layer may be arranged on the second inorganic encapsulation layer 430 of the encapsulation layer 400 and flatten a surface on which the first touch electrode MT1 and the like are arranged. The insulating layer may include an inorganic insulating material, such as SiO₂, SiNₓ, or SiON. In some embodiments, the insulating layer may include an organic insulating material.

The first touch insulating layer 510 may be arranged on the first touch electrode MT1. The first touch insulating layer 510 may include an inorganic material or an organic material. When the first touch insulating layer 510 includes an inorganic material, the first touch insulating layer 510 may include at least one material selected from the group consisting of SiNₓ, aluminum nitride (AIN), zirconium nitride (ZrN), titanium nitride (TiN), hafnium nitride (HfN), tantalum nitride (TaN), SiO₂, Al₂O₃, TiO₂, tin oxide (SnO₂), cerium oxide (CeO₂), and SiON. When the first touch insulating layer 510 includes an organic material, the first touch insulating layer 510 may include at least one material selected from the group consisting of acrylic resin, methacrylic resin, polyisoprene, vinyl-based resin, epoxy-based resin, urethane-based resin, cellulose-based resin, and perylene-based resin.

The second touch electrode MT2 may be arranged on the first touch insulating layer 510. The second touch electrode MT2 may function as a sensor for sensing a touch input from a user. The first touch electrode MT1 may function as a connecting portion for connecting, in a direction, the second touch electrode MT2 that is patterned. In an embodiment, both the first touch electrode MT1 and the second touch electrode MT2 may function as sensors. In this case, the first touch electrode MT1 may be electrically connected to the second touch electrode MT2 through a contact hole. When both the first touch electrode MT1 and the second touch electrode MT2 function as sensors, the resistance of the touch electrodes may be reduced, and thus, the touch input from the user may be quickly detected.

In an embodiment, the first touch electrode MT1 and the second touch electrode MT2 may have a structure, for example, a mesh structure, which allows light from the light-emitting diode to pass through. In this case, the first touch electrode MT1 and the second touch electrode MT2 may be arranged not to overlap the emission area of the light-emitting diode.

The first touch electrode MT1 and the second touch electrode MT2 may each include a metal layer or a transparent conductive layer. The metal layer may include Mo, Ag, Ti, Cu, Al, and an alloy thereof. The transparent conductive layer may include transparent conductive oxide, such as ITO, IZO, ZnO, or ITZO, a conductive polymer such as PEDOT, metal nanowires, carbon nanotubes, graphene, or the like.

The second touch insulating layer 520 may be arranged on the second touch electrode MT2. The second touch insulating layer 520 may include an inorganic material or an organic material. When the second touch insulating layer 520 includes an inorganic material, the second touch insulating layer 520 may include at least one material selected from the group consisting of SiNₓ, AIN, ZrN, TiN, HfN, TaN, SiO₂, Al₂O₃, TiO₂, SnO₂, CeO₂, and SiON. When the second touch insulating layer 520 includes an organic material, the second touch insulating layer 520 may include at least one material selected from the group consisting of acrylic resin, methacrylic resin, polyisoprene, vinyl-based resin, epoxy-based resin, urethane-based resin, cellulose-based resin, and perylene-based resin.

Referring to FIGS. 5 and 6, the touch sensor layer 500 may further include a reflective pattern RP arranged at the same layer (or in the same layer) as the second touch electrode MT2. The reflective pattern RP may be arranged apart from the second touch electrode MT2 and be in a floating state. The reflective pattern RP may be arranged on the first touch insulating layer 510 and within a trench TC of the first touch insulating layer 510. Here, the trench TC of the first touch insulating layer 510 may refer to a portion where the upper surface of the first touch insulating layer 510 is concavely recessed. As the reflective pattern RP is arranged within the trench TC, the shape of the reflective pattern RP may vary depending on the shape of the trench TC. For example, as shown in FIG. 6, the reflective pattern RP may have a V shape or a wing-like shape. Forming a trench TC in the lower touch insulating layer 510 at the center of the emission area EA allows the reflective pattern RP to be deposited within this recessed geometry. This structural integration saves vertical space and also defines the physical shape of the reflective pattern RP based on the trench's profile. This allows the reflective pattern RP to assume specific geometries optimized for directing reflected light. Providing the reflective pattern RP with a V shape or a wing-like shape in cross-section optimizes the optical path of recycled light. These specific angled shapes direct light emitted from the diode laterally or in specific directions rather than just reflecting it directly back. This mechanism increases the light extraction efficiency and improves the overall light recycling efficiency of the display device. The term "trench" is not limited to a linear groove but may be broadly referred to as a "recess" or "depression" of any shape (e.g., circular or polygonal) in a plan view. Similarly, the "V shape" or "wing-like shape" may be generalized as a "concave shape", "cup shape", or "shape having inclined sidewalls".

In an embodiment, the reflective pattern RP may be arranged to overlap the emission area of each of the first organic light-emitting diode OLED1 to the third organic light-emitting diode OLED3. For example, the reflective pattern RP may be arranged to overlap the central portion of the first emission area EA1, the second emission area EA2, or the third emission area EA3.

The reflective pattern RP may be arranged on the same layer and include the same material as the second touch electrode MT2. For example, the reflective pattern RP may include a metal layer or a transparent conductive layer. The reflective pattern RP may include Ag, an alloy containing Ag, Mo, an alloy containing Mo, Al, an alloy containing Al, AIN, tungsten (W), tungsten nitride (WN), Cu, Ni, Cr, chromium nitride (CrN), Ti, Ta, Pt, scandium (Sc), ITO, IZO, or the like.

As the reflective pattern RP including the aforementioned material is arranged to overlap the emission area, the reflective pattern RP may reflect light emitted from the light-emitting diode. In addition, the light reflected from the reflective pattern RP may be reflected again from a structure (e.g., a sub-pixel electrode) located under the reflective pattern RP and then may be emitted to the outside. Specifically, as shown in FIG. 6, when the reflective pattern RP has a wing-like shape, light emitted from the light-emitting diode may be directed in a lateral direction by the reflective pattern RP such that the light emission efficiency may increase. Accordingly, the recycling efficiency of light emitted from the light-emitting diode may be enhanced.

The optical control layer 600 may be arranged on the touch sensor layer 500. The optical control layer 600 may include a light-shielding layer 610, a light-shielding pattern 610D, a color filter layer 630, and an overcoat layer 640. In an embodiment, the optical control layer 600 may include a first color filter 630G, a second color filter 630B, and a third color filter 630R that emit light of different colors and correspond to the first organic light-emitting diode OLED1 to the third organic light-emitting diode OLED3, respectively. The first color filter 630G, the second color filter 630B, and the third color filter 630R may each be provided in plurality.

The optical control layer 600 may be arranged on the touch sensor layer 500. The optical control layer 600 may be directly arranged on the touch sensor layer 500, for example, the second touch insulating layer 520 corresponding to the uppermost portion of the touch sensor layer 500. The light-shielding layer 610, the light-shielding pattern 610D, and the color filter layer 630 forming the optical control layer 600 may be directly arranged on the touch sensor layer 500.

The light-shielding layer 610 may define the upper openings 610OP therein that correspond to the green sub-pixel Pg, the blue sub-pixel Pb, and the red sub-pixel Pr, respectively. Specifically, the light-shielding layer 610 may include the first upper opening 610OP1 corresponding to the first emission area EA1, the second upper opening 610OP2 corresponding to the second emission area EA2, and the third upper opening 610OP3 corresponding to the third emission area EA3. Light emitted from the first organic light-emitting diode OLED1 to the third organic light-emitting diode OLED3 may be emitted to the outside through the upper openings 610OP of the light-shielding layer 610.

Because the upper openings 610OP of the light-shielding layer 610 overlap the emission areas, the upper openings 610OP may overlap the lower openings 225OP of the bank layer 225. For example, the first upper opening 610OP1 of the light-shielding layer 610 may overlap the first lower opening 225OP1 of the bank layer 225, the second upper opening 610OP2 of the light-shielding layer 610 may overlap the second lower opening 225OP2 of the bank layer 225, and the third upper opening 610OP3 of the light-shielding layer 610 may overlap the third lower opening 225OP3 of the bank layer 225.

In an embodiment, the width (or size) of the upper opening 610OP of the light-shielding layer 610 may be greater than the width (or size) of the emission area of its corresponding sub-pixel. For example, the size of the first upper opening 610OP1 of the light-shielding layer 610 may be greater than the size of the first lower opening 225OP1 of the bank layer 225. Similarly, the size of the second upper opening 610OP2 of the light-shielding layer 610 may be greater than the size of the second lower opening 225OP2 of the bank layer 225, and the size of the third upper opening 610OP3 of the light-shielding layer 610 may be greater than the size of the third lower opening 225OP3 of the bank layer 225.

In another embodiment, the width (or size) of the upper opening 610OP of the light-shielding layer 610 may be substantially the same as the width (or size) of the emission area of its corresponding sub-pixel. For example, the size of the first upper opening 610OP1 of the light-shielding layer 610 may be substantially the same as the size of the first lower opening 225OP1 of the bank layer 225. Similarly, the size of the second upper opening 610OP2 of the light-shielding layer 610 may be substantially the same as the size of the second lower opening 225OP2 of the bank layer 225, and the size of the third upper opening 610OP3 of the light-shielding layer 610 may be substantially the same as the size of the third lower opening 225OP3 of the bank layer 225.

The light-shielding layer 610 may include an organic insulating material. Alternatively, the light-shielding layer 610 may include an inorganic insulating material, such as SiNₓ or SiO₂. In some embodiments, the light-shielding layer 610 may include an organic insulating material and an inorganic insulating material.

In an embodiment, the light-shielding layer 610 may include a light-shielding material. For example, the light-shielding material of the light-shielding layer 610 may be black. The light-shielding material may include carbon black, carbon nanotubes, resin or paste including a black dye, metal particles such as Ni, Al, Mo, and an alloy thereof, metal oxide particles, metal nitride particles, or the like. When the light-shielding layer 610 includes the light-shielding material, external light reflection from metal structures arranged under the light-shielding layer 610 may be reduced.

The optical control layer 600 may include the light-shielding pattern 610D that is arranged within the upper opening 610OP of the light-shielding layer 610 and spaced apart from the light-shielding layer 610. A plurality of light-shielding patterns 610D may be provided and may be spaced apart from each other to correspond to the sub-pixels, respectively. For example, the light-shielding patterns 610D may include a first light-shielding pattern 610D1 corresponding to the green sub-pixel Pg, a second light-shielding pattern 610D2 corresponding to the blue sub-pixel Pb, and a third light-shielding pattern 610D3 corresponding to the red sub-pixel Pr. The first light-shielding pattern 610D1 may be arranged to overlap the first emission area EA1 of the first organic light-emitting diode OLED1, the second light-shielding pattern 610D2 may be arranged to overlap the second emission area EA2 of the second organic light-emitting diode OLED2, and the third light-shielding pattern 610D3 may be arranged to overlap the third emission area EA3 of the third organic light-emitting diode OLED3.

As the light-shielding pattern 610D is arranged within the upper opening 610OP of the light-shielding layer 610, the light-shielding pattern 610D may be arranged to overlap the lower opening 225OP of the bank layer 225. For example, the first light-shielding pattern 610D1 may be arranged to overlap the first lower opening 225OP1, the second light-shielding pattern 610D2 may be arranged to overlap the second lower opening 225OP2, and the third light-shielding pattern 610D3 may be arranged to overlap the third lower opening 225OP3.

The width (or size) of the light-shielding pattern 610D may be less than the width (or size) of its corresponding sub-pixel. In other words, the area of the first light-shielding pattern 610D1 may be less than the area of the first lower opening 225OP1, the area of the second light-shielding pattern 610D2 may be less than the area of the second lower opening 225OP2, and the area of the third light-shielding pattern 610D3 may be less than the area of the third lower opening 225OP3 in a plan view. For example, the area of the light-shielding pattern 610D may be 20 % to 50 % of the area of the lower opening 225OP of the bank layer 225 in a plan view. For example, the area of the light-shielding pattern 610D may be 25 % to 45 % of the area of the lower opening 225OP of the bank layer 225 in a plan view, more preferably 30 % to 40 %. An area below 20% may not provide sufficient shielding or reflection surface for contrast improvement; an area above 50% significantly impedes light emission, reducing efficiency.

Referring to FIGS. 5 and 6, the light-shielding pattern 610D may be arranged to correspond to the reflective pattern RP. As described above, the reflective pattern RP of the touch sensor layer 500 may be arranged to overlap the emission area of the organic light-emitting diode. In this case, the light-shielding pattern 610D may be arranged on the reflective pattern RP to overlap the same.

In an embodiment, the second touch insulating layer 520 arranged on the reflective pattern RP may include an intermediate opening 520OP corresponding to the reflective pattern RP. For example, the second touch insulating layer 520 may define a first intermediate opening 520OP1 therein overlapping the reflective pattern RP arranged on the green sub-pixel Pg, a second intermediate opening 520OP2 overlapping the reflective pattern RP arranged on the blue sub-pixel Pb, and a third intermediate opening 520OP3 overlapping the reflective pattern RP arranged on the red sub-pixel Pr in a plan view. The intermediate opening 520OP of the second touch insulating layer 520 may expose the upper surface of the reflective pattern RP. The intermediate opening 520OP may be referred to as a "touch insulating layer opening".

In this case, the light-shielding pattern 610D may be arranged within the intermediate opening 520OP of the second touch insulating layer 520. For example, the first light-shielding pattern 610D1 may be arranged in the first intermediate opening 520OP1 of the second touch insulating layer 520, the second light-shielding pattern 610D2 may be arranged in the second intermediate opening 520OP2 of the second touch insulating layer 520, and the third light-shielding pattern 610D3 may be arranged in the third intermediate opening 520OP3 of the second touch insulating layer 520. Accordingly, the light-shielding pattern 610D may be arranged to directly contact the reflective pattern RP. In other words, the lower surface of the light-shielding pattern 610D may directly contact the upper surface of the reflective pattern RP, while the second touch electrode MT2 may be separated from the light-shielding layer 610 by the second touch insulating layer 520. By defining an intermediate opening 520OP in the upper touch insulating layer 520 that overlaps the reflective pattern RP, the light-shielding pattern 610D can be arranged directly within this opening 520OP. This arrangement exposes the underlying reflective pattern RP, which typically has a different surface energy (hydrophobicity) compared to the insulating layer 520. This difference in surface properties allows the light-shielding material to be patterned more finely within the opening 520OP than on the surrounding insulating layer 520, thereby enabling higher-resolution patterning for high-quality displays.

In an embodiment, the light-shielding pattern 610D may include the same material as the light-shielding layer 610. In other words, the light-shielding pattern 610D may include an organic insulating material or an inorganic insulating material and may further include a light-shielding material. For example, the light-shielding material of the light-shielding pattern 610D may be black. The light-shielding material may include carbon black, carbon nanotubes, resin or paste including a black dye, metal particles such as Ni, Al, Mo, and an alloy thereof, metal oxide particles, metal nitride particles, or the like. Similar to the light-shielding layer 610, the light-shielding pattern 610D may include a light-shielding material and thus may reduce the external light reflection from the metal structures arranged under the light-shielding pattern 610D. In some embodiments, the light-shielding pattern 610D may include a different material from a material of the light-shielding layer 610. For example, the light-shielding pattern 610D may include the same material as any one of the color filters described below.

In an embodiment, the light-shielding pattern 610D may be deposited through the same process as the light-shielding layer 610. However, the light-shielding layer 610 is arranged on the second touch insulating layer 520, and the light-shielding pattern 610D is arranged within the intermediate opening 520OP of the second touch insulating layer 520 such that the height of the upper surface of the light-shielding layer 610 may be different from the height of the upper surface of the light-shielding pattern 610D. In other words, the height of the upper surface of the light-shielding layer 610 may be different from the height of the upper surface of the light-shielding pattern 610D because of the step difference of the second touch insulating layer 520. For example, as shown in FIG. 6, the length H2 from the upper surface of the second touch insulating layer 520 to the upper surface of the light-shielding layer 610 may be greater than the length H1 from the upper surface of the second touch insulating layer 520 to the upper surface of the light-shielding pattern 610D.

When the display device 1 is designed to have high resolution, the light-shielding pattern 610D needs to be patterned more finely. In this case, the structure in which the light-shielding pattern 610D is arranged within the intermediate opening 520OP may allow finer patterning of the light-shielding pattern 610D, compared to the structure in which the light-shielding pattern 610D is arranged on the upper surface of the second touch insulating layer 520.

Specifically, the surface contact angle of the upper surface of the second touch insulating layer 520 may be different from the surface contact angle of the upper surface of the reflective pattern RP. For example, when the second touch insulating layer 520 includes SiNₓ that is an inorganic insulating material, and when the reflective pattern RP includes Al, the surface contact angle of the second touch insulating layer 520 may be 45 degrees, and the surface contact angle of the reflective pattern RP may be 60 degrees. The description that the surface contact angle of the reflective pattern RP is greater than the surface contact angle of the second touch insulating layer 520 may indicate that the reflective pattern RP is more hydrophobic than the second touch insulating layer 520. In other words, because the upper surface of the reflective pattern RP has lower surface energy than the upper surface of the second touch insulating layer 520, the material forming the light-shielding pattern 610D may have a tendency to reduce the contact area more on the upper surface of the second touch insulating layer 520 than on the upper surface of the reflective pattern RP. Ensuring that the surface contact angle of the reflective pattern RP is greater than that of the upper touch insulating layer 520 means the reflective pattern RP is more hydrophobic. Consequently, the light-shielding material has a lower tendency to spread on the reflective pattern RP compared to the insulating layer 520. This property restricts the light-shielding pattern 610D to a narrower area, enabling the formation of very fine line widths which allows for higher resolution displays without sacrificing optical performance.

In other words, the light-shielding pattern 610D may be patterned more finely on the upper surface of the reflective pattern RP than on the upper surface of the second touch insulating layer 520. In an embodiment, the line width of the light-shielding pattern 610D, which is arranged within the intermediate opening 520OP of the second touch insulating layer 520 and formed on the upper surface of the reflective pattern RP, may be in a range of 2 µm to 5 µm. As a result, the display device 1 according to an embodiment may provide excellent display quality even at high resolution as the intermediate opening 520OP is formed in the second touch insulating layer 520 and the light-shielding pattern 610D is formed on the reflective pattern RP, allowing finer patterning of the light-shielding pattern 610D. In an embodiment, the line width of the light-shielding pattern 610D, may be in a range of 2.5 µm to 4.5 µm, more preferably in a range of 3 µm to 4 µm. A width below 2 µm may lead to pattern stability issues (peeling), while a width above 5 µm may excessively reduce the aperture ratio, lowering brightness in high-resolution pixels.

Referring back to FIG. 5, the color filter layer 630 may be arranged on the light-shielding layer 610 and the light-shielding pattern 610D. In an embodiment, the color filter layer 630 may directly contact an upper surface and a side surface of the light-shielding pattern 610D protruding from the second touch insulating layer 520. The color filter layer 630 may include the first color filter 630G corresponding to the green sub-pixel Pg, the second color filter 630B corresponding to the blue sub-pixel Pb, and the third color filter 630R corresponding to the red sub-pixel Pr. In an embodiment, the first color filter 630G may be a green color filter, the second color filter 630B may be a blue color filter, and the third color filter 630R may be a red color filter.

The color filter layer 630 may be arranged on the light-shielding layer 610 and fill the upper opening 610OP of the light-shielding layer 610. Accordingly, the color filter layer 630 may cover the light-shielding pattern 610D. For example, the first color filter 630G may fill the first upper opening 610OP1 and cover the first light-shielding pattern 610D1. The second color filter 630B may fill the second upper opening 610OP2 and cover the second light-shielding pattern 610D2. The third color filter 630R may fill the third upper opening 610OP3 and cover the third light-shielding pattern 610D3. Filling the upper opening 610OP with a color filter layer 630 that covers the light-shielding pattern 610D ensures that the emitted light is properly filtered for color while protecting the underlying fine structures. This integration creates a compact optical stack where the light-shielding pattern 610D is embedded within the color filter 630, securing its position and ensuring that it effectively blocks reflection from the underlying reflective pattern RP without requiring additional separate layers.

The overcoat layer 640 may be arranged on the light-shielding layer 610 and the color filter layer 630. The overcoat layer 640 may flatten the upper surfaces of the light-shielding layer 610 and the color filter layer 630. In other words, the overcoat layer 640 may be integrally formed over the first color filter 630G, the second color filter 630B, and the third color filter 630R. The overcoat layer 640 may be a colorless transparent layer that does not exhibit a color in a visible wavelength band. The overcoat layer 640 may include a colorless transparent organic material, such as acrylic resin.

The cover window 700 may be arranged on the overcoat layer 640 with the adhesive layer OCA therebetween.

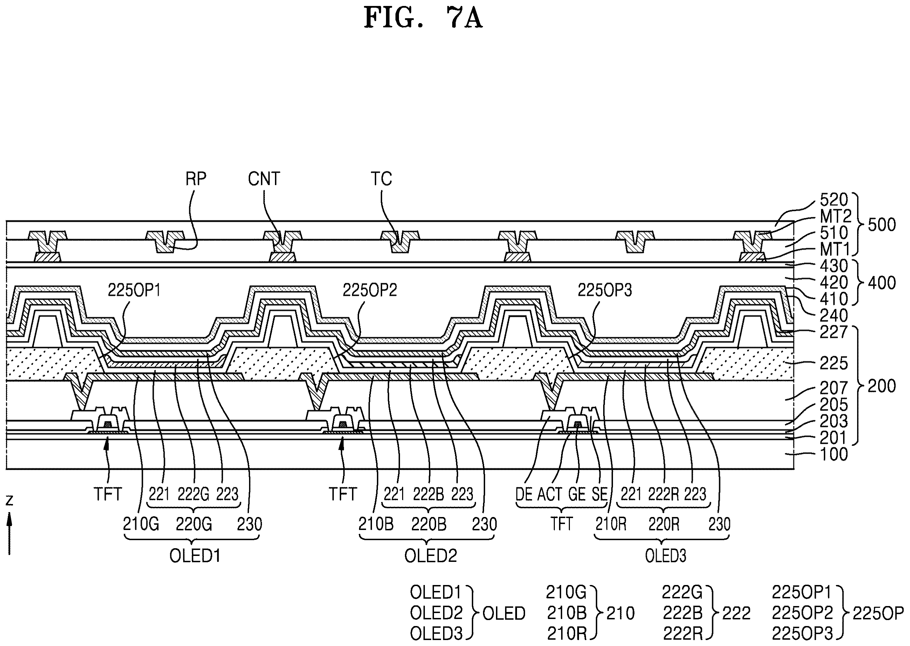

FIGS. 7A to 7D are schematic cross-sectional views illustrating a method of manufacturing a display device, according to an embodiment. The descriptions regarding the components indicated by the same reference symbols in FIGS. 7A to 7D are replaced with those provided above with reference to FIGS. 5 and 6.

First of all, referring to FIG. 7A, a buffer layer 201 may be formed on the substrate 100. A thin-film transistor TFT including a gate electrode GE, a semiconductor layer ACT, a source electrode SE, and a drain electrode DE may be formed on the buffer layer 201. A planarization layer 207 may be formed on the thin-film transistor TFT, and the organic light-emitting diode OLED may be formed on the planarization layer 207.

The organic light-emitting diode OLED may include a sub-pixel electrode 210, an emission layer 222, and an opposite electrode 230. The sub-pixel electrode 210 may be formed on the planarization layer 207, and the bank layer 225 may be formed on the planarization layer 207 to cover the edges of the sub-pixel electrode 210. The lower opening 225OP exposing the central portion of the sub-pixel electrode 210 may be formed in the bank layer 225. The emission layer 222 may be formed within the lower opening 225OP of the bank layer 225, and the opposite electrode 230 may be formed to cover the emission layer 222 and the bank layer 225.

The encapsulation layer 400 may be formed on the organic light-emitting diode OLED. The encapsulation layer 400 may be formed in the order of the first inorganic encapsulation layer 410, the organic encapsulation layer 420, and the second inorganic encapsulation layer 430.

The touch sensor layer 500 may be formed on the encapsulation layer 400. The touch sensor layer 500 may be formed in the order of the first touch electrode MT1, the first touch insulating layer 510, the second touch electrode MT2, and the second touch insulating layer 520. The first touch electrode MT1 may be formed to overlap the bank layer 225, and the first touch insulating layer 510 may be formed to cover the first touch electrode MT1.

A contact hole CNT and a trench TC may be formed in the first touch insulating layer 510. The contact hole CNT and the trench TC may be formed through the same process. For example, the contact hole CNT and the trench TC may be formed by forming, on the first touch insulating layer 510, a photoresist layer exposing a portion of the first touch insulating layer 510 and then by etching the exposed portion of the first touch insulating layer 510.

The second touch electrode MT2 and the reflective pattern RP may be formed on the first touch insulating layer 510. The second touch electrode MT2 and the reflective pattern RP may be formed through the same process. The second touch electrode MT2 and the reflective pattern RP may be arranged on the same layer and include the same material. However, the second touch electrode MT2 may be arranged to overlap the first touch electrode MT1, and the reflective pattern RP may be arranged to overlap the emission area. In this case, the second touch electrode MT2 may be electrically connected to the first touch electrode MT1 through the contact hole CNT, and the reflective pattern RP may be arranged within the trench TC and have a V shape or a wing-like shape. The reflective pattern RP may improve the light recycling efficiency by reflecting the light emitted from the light-emitting diode.

The second touch insulating layer 520 may be formed on the first touch insulating layer 510 to cover the second touch electrode MT2 and the reflective pattern RP.

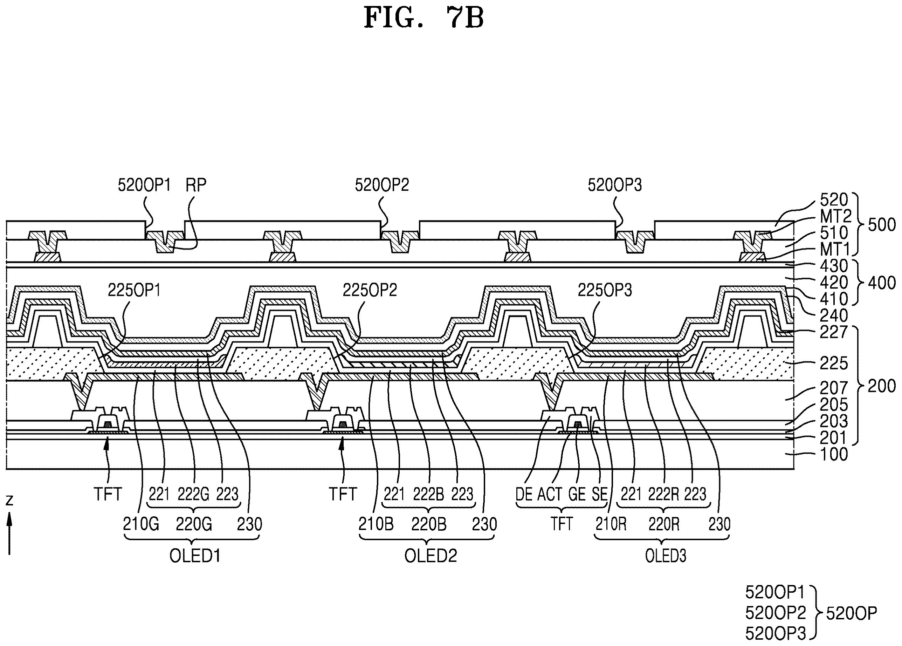

Next, referring to FIG. 7B, the intermediate opening 520OP may be formed in the second touch insulating layer 520. The intermediate opening 520OP may be formed by etching some portions of the second touch insulating layer 520 that overlap the reflective pattern RP. As the intermediate opening 520OP is formed in the second touch insulating layer 520, the upper surface of the reflective pattern RP may be exposed. Exposing the upper surface of the reflective pattern RP through the intermediate opening 520OP ensures direct physical contact between the reflective pattern RP and the subsequent light-shielding pattern 610D. This direct contact is advantageous for leveraging the specific surface characteristics (such as higher contact angle) of the reflective pattern material (e.g., metal) to control the spread and line width of the light-shielding material during formation, thus facilitating finer pattern dimensions.

The intermediate opening 520OP of the second touch insulating layer 520 may be formed through a dry etching process. The dry etching process may be a process of removing specific portions by using a reactive gas, ions, or the like. Thus, when the intermediate opening 520OP is formed through the dry etching process, finer patterning may be achieved compared to a wet etching process of removing specific portions through chemical methods.

In some embodiments, after the intermediate opening 520OP is formed in the second touch insulating layer 520, the upper surface of the reflective pattern RP, which is exposed through the intermediate opening 520OP of second touch insulating layer 520, may be surface-treated. Specifically, the upper surface of the reflective pattern RP may be surface-treated through plasma treatment or Self-Assembled Monolayer (SAM) treatment. When the reflective pattern RP is surface-treated, the upper surface of the reflective pattern RP may have a greater surface contact angle than before the surface treatment.

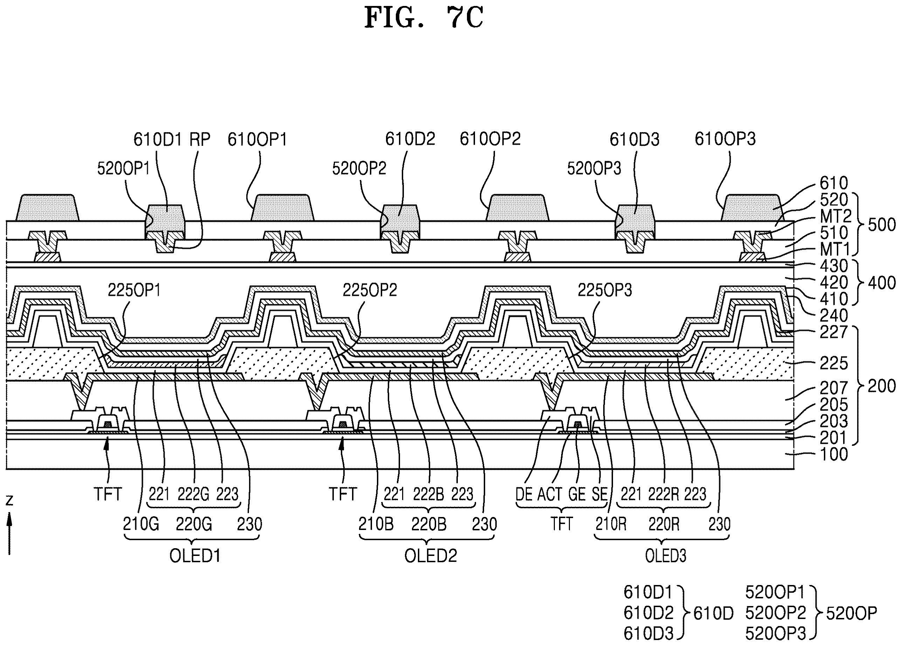

Referring to FIG. 7C, after the intermediate opening 520OP is formed in the second touch insulating layer 520, the light-shielding layer 610 and the light-shielding pattern 610D may be formed. The light-shielding layer 610 and the light-shielding pattern 610D may be deposited through the same process. In an embodiment, the light-shielding layer 610 may include the same material as the light-shielding pattern 610D. For example, as the light-shielding layer 610 includes the same light-shielding material as the light-shielding pattern 610D, the external light reflectivity of the display device 1 may be reduced.

However, the light-shielding layer 610 may be formed to overlap the bank layer 225, the first touch electrode MT1, and the second touch electrode MT2, and the light-shielding pattern 610D may be formed to overlap the emission area. In other words, the light-shielding layer 610 may be formed on the upper surface of the second touch insulating layer 520, and the light-shielding pattern 610D may be formed within the intermediate opening 520OP of the second touch insulating layer 520.

As described above, the intermediate opening 520OP of the second touch insulating layer 520 may be finely patterned through the dry etching process. In addition, because the surface contact angle of the reflective pattern RP, which is exposed through the intermediate opening 520OP, is greater than the surface contact angle of the second touch insulating layer 520, the light-shielding pattern 610D formed on the reflective pattern RP may be patterned more finely than the light-shielding layer 610 formed on the second touch insulating layer 520. As a result, the light-shielding pattern 610D may be arranged within the intermediate opening 520OP of the second touch insulating layer 520 and thus have a narrow line width; thus, the display device 1 may exhibit excellent display quality even at high resolution.

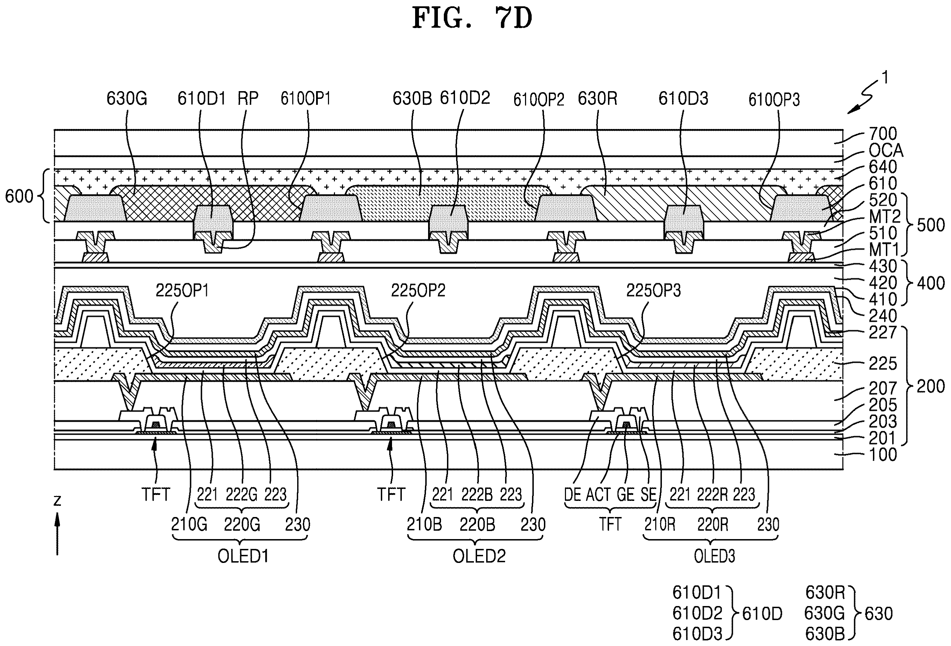

Next, referring to FIG. 7D, the color filter layer 630 may be formed on the light-shielding layer 610 and the light-shielding pattern 610D. The color filter layer 630 may fill the upper opening 610OP of the light-shielding layer 610 and cover the light-shielding pattern 610D. For example, the first color filter 630G may fill the first upper opening 610OP1 and cover the first light-shielding pattern 610D1. The second color filter 630B may fill the second upper opening 610OP2 and cover the second light-shielding pattern 610D2. The third color filter 630R may fill the third upper opening 610OP3 and cover the third light-shielding pattern 610D3.

The overcoat layer 640 may be formed on the light-shielding layer 610 and the color filter layer 630. The overcoat layer 640 may be flatten the upper surface of the optical control layer 600. The adhesive layer OCA and the cover window 700 may be formed on the optical control layer 600.

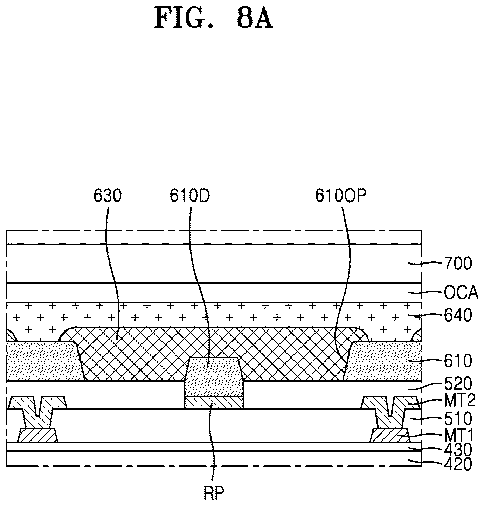

FIGS. 8A to 9D are schematic cross-sectional views of display devices according to embodiments. Referring to FIGS. 8A to 9D, except for the characteristics of the reflective pattern RP and the light-shielding pattern 610D, other characteristics are the same as those described above with reference to FIGS. 5 and 6. The descriptions regarding the components indicated by the same reference symbols in FIGS. 8A to 9D are replaced with those provided above with reference to FIGS. 5 and 6, and the differences therebetween are mainly described hereinafter.

First of all, referring to FIG. 8A, the reflective pattern RP may be arranged on the first touch insulating layer 510. The reflective pattern RP may be arranged on the same layer and include the same material as the second touch electrode MT2. In an embodiment, the reflective pattern RP may be arranged on the upper surface of the first touch insulating layer 510. Accordingly, the reflective pattern RP may have a bar shape or a flat shape. An opening overlapping the reflective pattern RP having the above-described structure may be formed in the second touch insulating layer 520, and the light-shielding pattern 610D may be arranged within the opening of the second touch insulating layer 520.

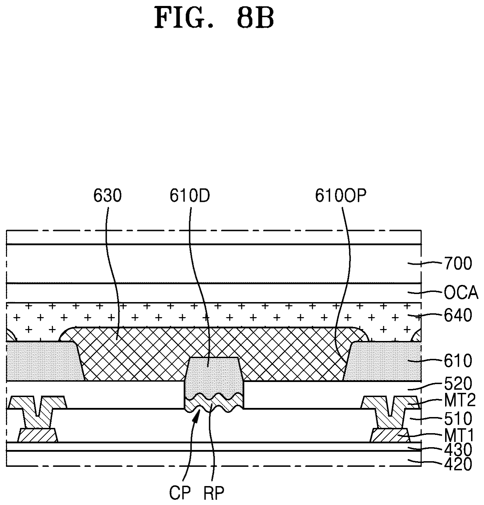

Next, referring to FIG. 8B, the reflective pattern RP may be arranged on the first touch insulating layer 510. The reflective pattern RP may be arranged on the same layer and include the same material as the second touch electrode MT2. **In** an embodiment, a portion of the upper surface of the first touch insulating layer 510 may include a curved portion CP. The curved portion CP of the first touch insulating layer 510 is formed to overlap the emission area of the light-emitting diode and may be a region where a plurality of concave portions and a plurality of convex portions are repeatedly arranged. In this case, the reflective pattern RP may be arranged on the curved portion CP of the first touch insulating layer 510. Accordingly, the reflective pattern RP may have a wave shape. An opening overlapping the reflective pattern RP having the above-described structure may be formed in the second touch insulating layer 520, and the light-shielding pattern 610D may be arranged within the opening of the second touch insulating layer 520.

As shown in FIGS. 8A and 8B, even when the reflective pattern RP has a flat shape or a wave shape, a portion of the light emitted from the light-emitting diode may be reflected from the reflective pattern RP and re-reflected from the lower structures of the reflective pattern RP, thereby being emitted to the outside. In other words, the display device according to an embodiment may have improved light recycling efficiency by using the reflective pattern RP having the above structure and also have reduced external light reflectivity by using the light-shielding pattern 610D. Specifically, when the reflective pattern RP has a wave shape, the traveling direction of the light emitted from the light-emitting diode and reflected from the reflective pattern RP may vary, and thus, the light extraction efficiency of the display device 1 may be further enhanced. Arranging the reflective pattern RP on the upper surface of the lower touch insulating layer 510 in a flat or wave shape provides alternative mechanisms for light recycling. A flat shape offers a simple reflective surface to bounce light back for recycling, while a wave shape (formed over a curved portion CP of the underlying layer) varies the reflection angles. This variation in reflection angles helps to scatter light and further enhances the light extraction efficiency. The "wave shape" may be generalized as an "undulating shape", a "corrugated shape", or a "shape comprising alternating convex and concave portions".

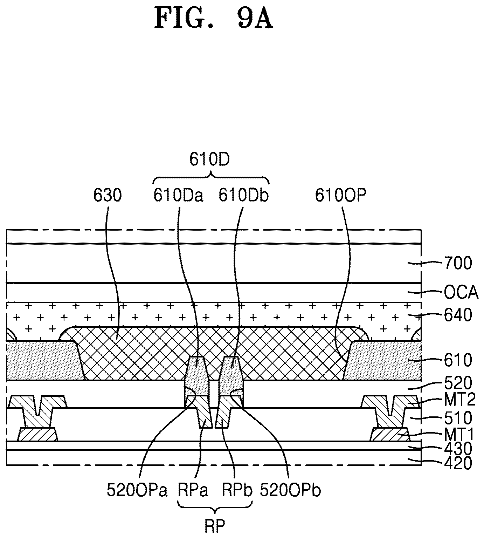

Referring to FIGS. 9A to 9D, the reflective pattern RP may include a first sub-reflective pattern RPa and a second sub-reflective pattern RPb that are spaced apart from each other. Each of the first sub-reflective pattern RPa and the second sub-reflective pattern RPb may be arranged on the first touch insulating layer 510 and include the same material as the second touch electrode MT2. Each of the first sub-reflective pattern RPa and the second sub-reflective pattern RPb may be arranged to overlap the emission area.

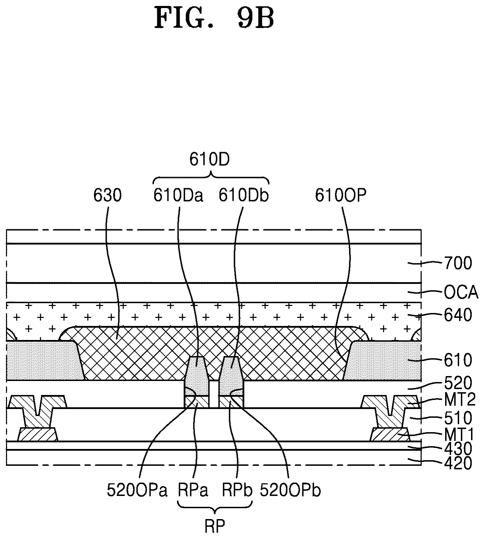

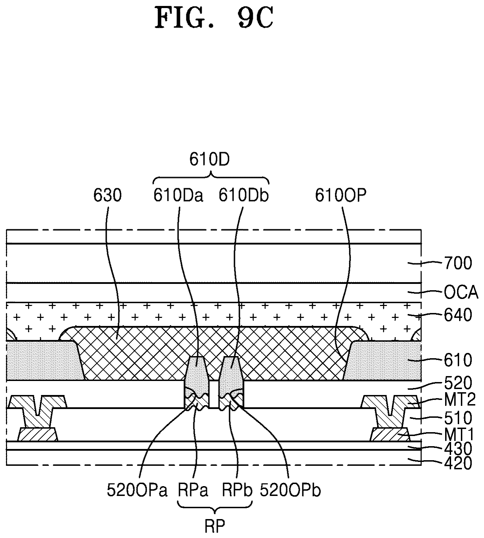

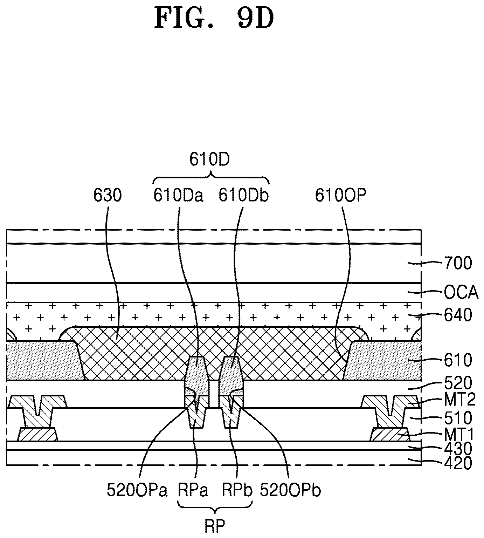

As described above, even when the first sub-reflective pattern RPa and the second sub-reflective pattern RPb of the reflective pattern RP are spaced apart from each other, the reflective pattern RP may have various shapes. For example, as shown in FIG. 9A, each of the first sub-reflective pattern RPa and the second sub-reflective pattern RPb may have a slanted shape with inclined side surfaces. Alternatively, as shown in FIG. 9B, each of the first sub-reflective pattern RPa and the second sub-reflective pattern RPb may have a bar shape or a flat shape. Alternatively, as shown in FIG. 9C, each of the first sub-reflective pattern RPa and the second sub-reflective pattern RPb may have a wave shape. Alternatively, as shown in FIG. 9D, each of the first sub-reflective pattern RPa and the second sub-reflective pattern RPb may have a V shape or a wing-like shape.

The second touch insulating layer 520 may be arranged to cover the second touch electrode MT2 and the reflective pattern RP. An opening may be formed in the second touch insulating layer 520 to correspond to the reflective pattern RP. Thus, the second touch insulating layer 520 may include a first sub-opening 520OPa overlapping the first sub-reflective pattern RPa and a second sub-opening 520OPb overlapping the second sub-reflective pattern RPb.

The light-shielding pattern 610D may be arranged within the opening of the second touch insulating layer 520 that overlaps the reflective pattern RP. In other words, the light-shielding pattern 610D may include a first sub-light-shielding pattern 610Da in the first sub-opening 520OPa and a second sub-light-shielding pattern 610Db in the second sub-opening 520OPb. The first sub-light-shielding pattern 610Da and the second sub-light-shielding pattern 610Db may be formed through the same process and include the same material as the first light-shielding layer 610. The first sub-light-shielding pattern 610Da may be spaced apart from the second sub-light-shielding pattern 610Db. The first sub-light-shielding pattern 610Da may be arranged on the first sub-reflective pattern RPa, and the second sub-light-shielding pattern 610Db may be arranged on the second sub-reflective pattern RPb.

As shown in FIGS. 9A to 9D, when the reflective pattern RP includes the first sub-reflective pattern RPa and the second sub-reflective pattern RPb that are spaced apart from each other, the outer periphery of the reflective pattern RP may be longer than when the reflective pattern RP is integrally formed as a single integrated pattern. That is, when the reflective pattern RP includes the first sub-reflective pattern RPa and the second sub-reflective pattern RPb, the light reflected from the surface of the reflective pattern RP may increase. In other words, the light recycling efficiency of the display device 1 may be improved. In addition, as the light-shielding pattern 610D includes the first sub-light-shielding pattern 610Da and the second sub-light-shielding pattern 610Db that are spaced apart from each other, it is possible to enhance the emission efficiency while efficiently reducing the external light reflectivity. As a result, the display device 1 according to an embodiment may include the first sub-reflective pattern RPa and the second sub-reflective pattern RPb that are spaced apart from each other and also include the first sub-light-shielding pattern 610Da and the second sub-light-shielding pattern 610Db that are spaced apart from each other; thus, the display quality of the display device 1 may be efficiently improved. Dividing the reflective pattern RP into spaced-apart sub-patterns RPa/RPb increases the total length of the outer periphery of the reflective material compared to a single solid pattern. This increased edge area enhances the scattering and reflection of light, thereby improving light recycling efficiency. Correspondingly splitting the light-shielding pattern 610D ensures that external light reflection is suppressed over each specific sub-reflective element, balancing emission efficiency with contrast performance.

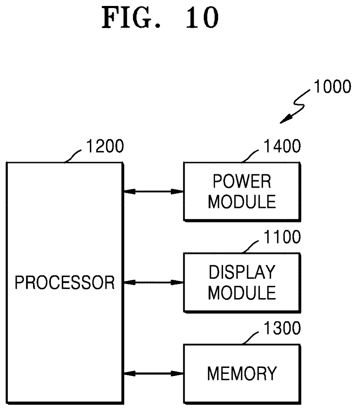

FIG. 10 is a block diagram of an electronic device according to an embodiment.

Referring to FIG. 10, an electronic device 1000 according to an embodiment may include a display module 1100, a processor 1200, a memory 1300, and a power module 1400.

The electronic device 1000 may use the display module 1100 to output various types of information under the operating system.

The processor 1200 may include at least one of a Central Processing Unit (CPU), an Application Processor (AP), a Graphics Processing Unit (GPU), a Communication Processor (CP), an Image Signal Processor (ISP), or a controller. In an embodiment, the processor 1200 may be divided into at least two processors from a functional or structural perspective. For example, the processor 1200 may include a main processor in the form of a first driving chip, which includes a CPU, and an auxiliary processor in the form of a second driving chip, which includes a controller that receives an image signal from the main processor and processes the same to conform to the interface specifications of the display module 1100.

The memory 1300 may include at least one of non-volatile memory or volatile memory. In the memory 1300, data information required for the operation of the processor 1200 or the display module 1100 may be stored. When the processor 1200 executes an application stored in the memory 1300, an image data signal and/or an input control signal may be transmitted to the display module 1100, and the display module 1100 may process such signals to output image information through a display screen.

The power module 1400 may include a power supply module, such as a power adaptor or a battery device, and a power conversion module that generates power required for the operation of the electronic device 1000 by converting the power supplied by the power supply module. The power conversion by the power conversion module may include DC-DC conversion, AC-DC conversion, and DC-AC conversion, but is not limited thereto.

At least one of the components of the electronic device 1000 described above may be included in the display device according to the one or more embodiments. In addition, some of individual modules functionally included in a single module may be included in the display device, and others thereof may be provided separately from the display device. For example, the display device may include the display module 1100 and the auxiliary processor of the processor 1200, and the main processor of the processor 1200, the memory 1300, and the power module 1400 may be provided as separate devices in the electronic device 1000, rather than in the display device. As another example, the power module 1400 may be included in the display device and supply power to the processor 1200 and the memory 1300 provided in the electronic device 1000, rather than in the display device, and one or more embodiments are not limited thereto.

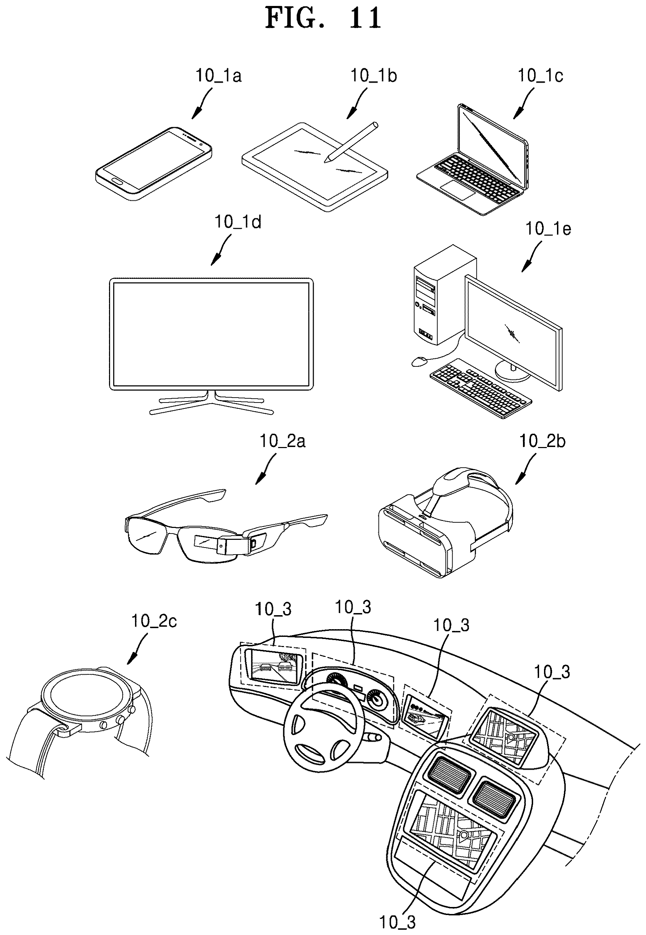

FIG. 11 is a schematic diagram of electronic devices according to embodiments.

The display device according to one or more embodiments is a device that displays a moving image or a still image and is applicable to various electronic devices. Referring to FIG. 11, examples of various electronic devices to which the display device according to embodiments is applied may include: electronic devices for image display, such as a smartphone 10_1a, a tablet personal computer (PC) 10_1b, a laptop 10_1c, a television (TV) 10_1d, or a desktop monitor 10_1e; wearable electronic devices including a display module, such as smart glasses 10_2a, a head-mounted display 10_2b, or a smart watch 10_2c; and vehicle electronic devices 10_3 with a display module, such as an instrument cluster of a vehicle, center fascia, a Center Information Display (CID) on the dashboard, or a room mirror display. The electronic device 1000 according to embodiments is not limited to the devices stated above.

The electronic device of FIG. 11 may include the components shown in FIG. 10. For example, the smartphone 10_1a may include the display module 1100, the processor 1200, the memory 1300, and the power module 1400 shown in FIG. 10. The smartphone 10_1a may further include a communication module and a battery device. The power supplied by the battery device may be converted through the power module 1400 and provided to the processor 1200, the memory 1300, and the display module 1100. In an embodiment, the display device applied to the smartphone 10_1a may include the display module 1100 and further include the power module 1400. The processor 1200 and the memory 1300 may be provided in the form of chips mounted on a motherboard that is an external device, but one or more embodiments are not limited thereto.

One or more embodiments may provide a display device with improved display quality, an electronic device including the display device, and a method of manufacturing a display device. The above effect is merely an example, and the scope of the disclosure is not limited thereto.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A display device (1) comprising:
a substrate (100);
a display layer (200) arranged on the substrate (100) and comprising a light-emitting diode (OLED) and a bank layer (225), which defines a lower opening (225OP) therein defining an emission area (EA) of the light-emitting diode (OLED);
a touch sensor layer (500) arranged on the display layer (200) and comprising an upper touch electrode (MT2) and an upper touch insulating layer (520) covering the upper touch electrode (MT2); and
an optical control layer (600) arranged on the touch sensor layer (500) and comprising a light-shielding layer (610) and a light-shielding pattern (610D), wherein the light-shielding layer (610) defines an upper opening (610OP) therein overlapping the lower opening (225OP) in a plan view, and the light-shielding pattern (610D) is arranged within the upper opening (610OP),
wherein the touch sensor layer (500) further comprises a reflective pattern (RP), which is arranged at a same layer as the upper touch electrode (MT2) and overlaps the emission area (EA) in the plan view,
the light-shielding pattern (610D) is arranged on the reflective pattern (RP) to cover the reflective pattern (RP) in the plan view, and
an upper surface of the reflective pattern (RP) directly contacts a lower surface of the light-shielding pattern (610D).

2. The display device (1) of claim 1, wherein the upper touch insulating layer (520) defines an intermediate opening (520OP) therein overlapping the reflective pattern (RP), and
the light-shielding pattern (610D) is arranged within the intermediate opening (520OP).

3. The display device (1) of claim 2, wherein the upper surface of the reflective pattern (RP) is exposed by the intermediate opening (520OP), and/or
wherein a surface contact angle of the reflective pattern (RP) is greater than a surface contact angle of the upper touch insulating layer (520).

4. The display device (1) of any one of the preceding claims, wherein a length (H2) from an upper surface of the upper touch insulating layer (520) to an upper surface of the light-shielding layer (610) is greater than a length (H1) from the upper surface of the upper touch insulating layer (520) to an upper surface of the light-shielding pattern (610D).

5. The display device (1) of any one of the preceding claims, wherein the touch sensor layer (500) further comprises a lower touch electrode (MT1) arranged under the upper touch electrode (MT2) and a lower touch insulating layer (510) arranged between the upper touch electrode (MT2) and the lower touch electrode (MT1), and
the upper touch electrode (MT2) is electrically connected to the lower touch electrode (MT1).

6. The display device (1) of claim 5, wherein the lower touch insulating layer (510) defines a trench (TC) located at a center of the emission area (EA), and
the reflective pattern (RP) is arranged within the trench (TC).

7. The display device (1) of claim 6, wherein the reflective pattern (RP) has a V shape or a wing-like shape in a cross-sectional view.

8. The display device (1) of claim 5, wherein the reflective pattern (RP) is arranged on an upper surface of the lower touch insulating layer (510), and
the reflective pattern (RP) has a flat shape or a wave shape in a cross-sectional view.

9. The display device (1) of any one of the preceding claims, wherein the light-shielding pattern (610D) is spaced apart from the light-shielding layer (610) and comprises a same material as the light-shielding layer (610).

10. The display device (1) of any one of the preceding claims, wherein the optical control layer (600) further comprises a color filter layer (630), which is arranged on the light-shielding layer (610) and fills the upper opening (610OP), and
the color filter layer (630) covers the light-shielding pattern (610D).

11. The display device (1) of any one of the preceding claims, wherein the reflective pattern (RP) comprises a first sub-reflective pattern (RPa) and a second sub-reflective pattern (RPb), which are arranged apart from each other,
the light-shielding pattern (610D) comprises a first sub-light-shielding pattern (610Da) arranged on the first sub-reflective pattern (RPa) and a second sub-light-shielding pattern (610Db) arranged on the second sub-reflective pattern (RPb), and
the first sub-light-shielding pattern (610Da) is spaced apart from the second sub-light-shielding pattern (610Db).

12. A method of manufacturing a display device (1), the method comprising:
forming, on a substrate (100), a display layer (200) comprising a light-emitting diode (OLED);
patterning a first touch electrode (MT1) on the display layer (200);
depositing a first touch insulating layer (510) to cover the first touch electrode (MT1);
patterning, on the first touch insulating layer (510), a second touch electrode (MT2) electrically connected to the first touch electrode (MT1) and a reflective pattern (RP) overlapping an emission area (EA) of the light-emitting diode (OLED);
depositing a second touch insulating layer (520) to cover the second touch electrode (MT2) and the reflective pattern (RP);
forming, in the second touch insulating layer (520), a touch insulating layer opening (520OP) overlapping the reflective pattern (RP) in a plan view; and
forming a light-shielding layer (610) arranged on the second touch insulating layer and a light-shielding pattern (610D) arranged within the touch insulating layer opening (520OP).

13. The method of claim 12, wherein the forming of the touch insulating layer opening (520OP) comprises removing some portions of the second touch insulating layer (520), which overlap the reflective pattern (RP), through a dry etching process, and/ or
wherein the light-shielding layer (610) and the light-shielding pattern (610D) are formed through a same process and comprise a same material.

14. The method of claims 12 or 13, further comprising performing surface treatment on an upper surface of the reflective pattern (RP), which is exposed through the touch insulating layer opening after the forming of the touch insulating layer opening and before the forming of the light-shielding pattern (610D),
wherein the upper surface of the reflective pattern (RP) is surface-treated through plasma treatment or Self-assembled monolayer (SAM) treatment.

15. An electronic device (1000) comprising:
a display device (1) according to any one of the claims 1 to 11, which is configured to provide an image; and
a housing, which accommodates the display device (1),
wherein the display device (1) further comprises at least one of a display module (1100), a processor (1200), a memory (1300), or a power module (1400).
